# EUROPEAN PATENT APPLICATION

(11) **EP 4 492 944 A1**
(43) Date of publication of application: **15.01.2025**
(21) Application number: 24181328.6
(22) Date of filing: 11.06.2024
(51) Int. Cl.: H10K 59/126

(54) **ELECTRONIC DEVICE**

(30) Priority: 16.06.2023 KR 20230077739
(71) Applicant: Samsung Display Co., Ltd., Yongin-si, Gyeonggi-do 17113 (KR)
(72) Inventor: SHIN, Seunghoon, 17113 Giheung-Gu, Yongin-si (KR); MOON, Joong-Soo, 17113 Giheung-Gu, Yongin-si (KR); PARK, Jinwoo, 17113 Giheung-Gu, Yongin-si (KR); NA, Jisu, 17113 Giheung-gu, Yongin-si (KR); PARK, Hyungjun, 17113 Giheung-gu, Yongin-si (KR); PYON, Changsoo, 17113 Giheung-gu, Yongin-si (KR); LEE, Jae Yong, 17113 Giheung-gu, Yongin-si (KR)
(74) Representative: Dr. Weitzel & Partner

(57) **Abstract**

An electronic device includes a base layer, at least one transistor including a semiconductor pattern on the base layer and a gate electrode on the semiconductor pattern, a connection electrode on the at least one transistor, at least one insulating layer located between the semiconductor pattern and the connection electrode, a side light shielding pattern located at a same layer as that of the connection electrode, and a light emitting element on the connection electrode and electrically connected to the at least one transistor. The connection electrode passes through the at least one insulating layer to be connected to the semiconductor pattern, and the side light shielding pattern passes through the at least one insulating layer.

## Description

### BACKGROUND

### 1. Field

The present invention described herein relates to an electronic device, and for example, to an electronic device including a transmissive area having relatively high transmittance.

### 2. Description of the Related Art

An electronic device may include a device including one or more suitable electronic components such as a display panel and/or an electronic module. The electronic module may include a camera, an infrared sensor, a proximity sensor, and/or the like. The electronic module may be disposed below the display panel. Transmittance of a partial area of the display panel may be higher than transmittance of the other partial area of the display panel. The electronic module may receive an external input through the partial area of the display panel and/or provide an output through the partial area of the display panel.

### SUMMARY

The present invention provides an electronic device having improved display quality. The invention is defined by the features of the independent claims. The dependent claims describe preferred embodiments.

The electronic device may include a transmissive area having relatively high transmittance within a display area.

According to one or more embodiments of the present invention, an electronic device includes a base layer, at least one transistor including a semiconductor pattern on the base layer and a gate electrode on the semiconductor pattern, a connection electrode on the at least one transistor, at least one insulating layer between the semiconductor pattern and the connection electrode, a side light shielding pattern on a same layer as that of the connection electrode, and a light emitting element on the connection electrode and electrically connected to the at least one transistor, wherein the connection electrode passes through the at least one insulating layer and is electrically connected to the semiconductor pattern, and the side light shielding pattern passes through the at least one insulating layer.

The side light shielding pattern may extend in one direction on a plane, and the semiconductor pattern may overlap the side light shielding pattern when viewed in a direction that defines a plane together with the one direction and crosses the one direction. In other words, in a direction parallel to the base layer, which also may be termed as a base substrate, the semiconductor pattern is beside the side light shielding pattern, especially between a first side pattern and a second side pattern of the side light shielding pattern.

The electronic device may further include a lower light shielding pattern located between the base layer and the semiconductor pattern, wherein the at least one transistor overlaps the lower light shielding pattern on a plane.

The electronic device may further include a lower insulating layer between the lower light shielding pattern and the semiconductor pattern, wherein the side light shielding pattern overlaps the lower light shielding pattern on a plane and further passes through the lower insulating layer to be in contact with the lower light shielding pattern.

The electronic device may further include a light absorbing pattern on a same layer as that of the semiconductor pattern and including a same material as that of the semiconductor pattern, wherein the side light shielding pattern is in contact with the light absorbing pattern.

The side light shielding pattern may include a first side pattern and a second side pattern that extend in a first direction on a plane and are spaced from each other in a second direction crossing the first direction with the at least one transistor interposed therebetween on a plane.

The at least one transistor may overlap the first side pattern and the second side pattern when viewed in the second direction.

The electronic device may further include a first light absorbing pattern and a second light absorbing pattern that are spaced from each other in the second direction with the at least one transistor interposed therebetween, each of the first light absorbing pattern and the second light absorbing pattern extends in the first direction, and are arranged on a same layer as that of the semiconductor pattern, wherein the first side pattern overlaps the first light absorbing pattern and is in contact with the first light absorbing pattern, and the second side pattern overlaps the second light absorbing pattern and is in contact with the second light absorbing pattern.

The light emitting element includes a plurality of light emitting elements, and the plurality of light emitting elements may include first light emitting elements each configured to emit a light beam having a first color to a first light emitting area, second light emitting elements each configured to emit a light beam having a second color that is different from the first color to a second light emitting area, and third light emitting elements each configured to emit a light beam having a third color that is different from the first color and the second color to a third light emitting area, one first pixel element (or pixel) of the first light emitting elements, two second pixel elements (or pixels) of the second light emitting elements, and one third pixel element (or pixel) of the third light emitting elements may be arranged in one pixel group, and the one pixel group may be repeatedly arranged along the first direction in one pixel row.

In the one pixel group, the first light emitting area of the one first pixel element (or pixel) and the third light emitting area of the one third pixel element (or pixel) may be spaced from each other in the first direction, and the second light emitting areas of the two second pixel elements (or pixels) may be spaced from each other in a direction that crosses the first direction and the second direction with the third light emitting area of the one third pixel element interposed therebetween.

The base layer may include a component area including a transmissive area and an element area, and a main display area adjacent to the component area, and the light emitting elements may overlap the element area and the main display area and may not overlap the transmissive area.

A plurality of transmissive areas including the transmissive area and a plurality of element areas including the element area may be arranged in the base layer, and the transmissive areas and the element areas may be arranged to alternate with each other in the second direction inside the component area, and the one pixel row may overlap the element areas.

The first side pattern and the second side pattern may be arranged to overlap each of the element areas.

The electronic device may further include first pixel circuits electrically connected to respective ones of the first light emitting elements, second pixel circuits electrically connected to respective ones of the second light emitting elements, and third pixel circuits electrically connected to respective ones of the third light emitting elements, wherein each of the first to third pixel circuits includes the at least one transistor and the connection electrode, and in the one pixel group, one of the first pixel circuits, one of two of the second pixel circuits, one of the third pixel circuits, and another one of the two of the second pixel circuits are arranged along the first direction.

The electronic device may further include an upper light shielding pattern overlapping at least a portion of the semiconductor pattern on a plane, wherein the light emitting element includes a first electrode on the connection electrode and electrically connected to the connection electrode, a light emitting layer on the first electrode, and a second electrode on the light emitting layer, and the upper light shielding pattern is at a same layer as that of the first electrode.

The electronic device may further include an upper connection electrode located between the connection electrode and the light emitting element and electrically connected between the connection electrode and the light emitting element, and an upper light shielding pattern overlapping at least a portion of the semiconductor pattern on a plane and located at a same layer as that of the upper connection electrode.

The at least one insulating layer may include a first insulating layer located between the semiconductor pattern and the gate electrode, and a second insulating layer located between the gate electrode and the connection electrode, and the side light shielding pattern may continuously pass through the first insulating layer and the second insulating layer.

The electronic device may further include at least one additional transistor including an additional semiconductor pattern located between the gate electrode and the connection electrode, that is in a layer that also passes between the gate electrode and the connection electrode, and an additional gate electrode located between the additional semiconductor pattern and the connection electrode, that is in a layer that also passes between the additional semiconductor pattern and the connection electrode, wherein the at least one insulating layer further includes a third insulating layer located between the gate electrode and the additional semiconductor pattern, a fourth insulating layer located between the additional semiconductor pattern and the additional gate electrode, and a fifth insulating layer located between the additional gate electrode and the connection electrode, and the side light shielding pattern continuously passes through the first to fifth insulating layers.

The side light shielding pattern may include a same material as that of the connection electrode.

According to one or more embodiments of the present invention, an electronic device includes a pixel circuit including at least one transistor including semiconductor patterns and a gate electrode on the semiconductor patterns, a light emitting element electrically connected to the pixel circuit, and a side light shielding pattern including a first side pattern and a second side pattern that are spaced from each other in one direction with the pixel circuit interposed therebetween on a plane, wherein the semiconductor patterns overlap each of the first side pattern and the second side pattern when viewed in the one direction. That is, in the one direction, which is a direction parallel to a base layer, which also may be termed as a base substrate, the semiconductor pattern is between the first side pattern and the second side pattern.

### BRIEF DESCRIPTION OF THE DRAWINGS

The above and other aspects and features of embodiments of the present invention will become apparent by describing in more detail embodiments thereof with reference to the accompanying drawings.
FIG. 1 is a perspective view of an electronic device according to one or more embodiments of the present invention.
FIG. 2A is an exploded perspective view of the electronic device according to one or more embodiments of the present invention.
FIG. 2B is a block diagram of the electronic device according to one or more embodiments of the present invention.
FIG. 2C is a cross-sectional view of an electronic panel according to one or more embodiments of the present invention.
FIG. 3A is a plan view of a display panel according to one or more embodiments of the present invention.
FIG. 3B is an equivalent circuit diagram of a pixel according to one or more embodiments of the present invention.
FIG. 4A is an enlarged plan view of a portion of a first area of the display panel according to one or more embodiments of the present invention.
FIG. 4B is an enlarged plan view of a portion of a second area of the display panel according to one or more embodiments of the present invention.
FIG. 5A is a cross-sectional view illustrating the first area of the display panel according to one or more embodiments of the present invention.
FIG. 5B is a cross-sectional view illustrating the second area of the display panel according to one or more embodiments of the present invention.
FIG. 6A is a plan view illustrating a portion of a lower light shielding pattern disposed in the second area of the display panel according to one or more embodiments of the present invention.
FIGS. 6B - 6H are plan views illustrating one layer constituting pixel circuits each arranged in the second area of the display panel according to one or more embodiments of the present invention.
FIG. 6I is a plan view illustrating one layer constituting a light emitting layer disposed in the second area of the display panel according to one or more embodiments of the present invention.
FIG. 7 is a cross-sectional view illustrating the second area of the display panel according to one or more embodiments of the present invention.
FIG. 8A is a plan view illustrating one layer constituting the pixel circuits arranged in the second area of the display panel according to one or more embodiments of the present invention.
FIG. 8B is a plan view illustrating one layer constituting the light emitting layer disposed in the second area of the display panel according to one or more embodiments of the present invention.
FIG. 9 is a cross-sectional view illustrating the second area of the display panel according to one or more embodiments of the present invention.
FIG. 10A is a plan view illustrating a portion of the lower light shielding pattern disposed in the second area according to one or more embodiments of the present invention.
FIG. 10B is a plan view illustrating the one layer constituting the pixel circuits arranged in the second area according to one or more embodiments of the present invention.

### DETAILED DESCRIPTION

In the present disclosure, the expression that a first component (or an area, a layer, a part, a portion, etc.) is "disposed on", "connected with" or "coupled to" a second component refers to that the first component is directly disposed on/connected with/coupled to the second component or refers to that a third component is interposed therebetween.

The same reference numerals refer to the same components. Further, in the drawings, the thickness, the ratio, and the dimension of components are exaggerated for effective description of technical contents. The term "and/or" includes all combinations of one or more components that may be defined by associated components.

Although the terms "first", "second", etc. may be utilized to describe one or more suitable components, the components should not be limited by the terms. The terms are only utilized to distinguish one component from another component. For example, without departing from the scope of the present invention, a first component may be referred to as a second component, and similarly, the second component may be also referred to as the first component. Singular expressions include plural expressions unless clearly otherwise indicated in the context.

Also, the terms "under", "below", "on", "above", etc. are utilized to describe the correlation of components illustrated in drawings. The terms that are relative in concept are described based on a direction illustrated in drawings.

It will be understood that the terms "include", "comprise", "have", etc. specify the presence of features, numbers, steps, operations, elements, or components, described in the present disclosure, or a combination thereof, and do not exclude in advance the presence or additional possibility of one or more other features, numbers, steps, operations, elements, or components or a combination thereof.

Unless otherwise defined, all terms (including technical terms and scientific terms) utilized in the present disclosure have the same meaning as commonly understood by those skilled in the art to which the present invention belongs. Furthermore, terms such as terms defined in the dictionaries commonly utilized should be interpreted as having a meaning consistent with the meaning in the context of the related technology and should not be interpreted in overly ideal or overly formal meanings unless explicitly defined herein.

Hereinafter, one or more embodiments of the present invention will be described with reference to accompanying drawings.

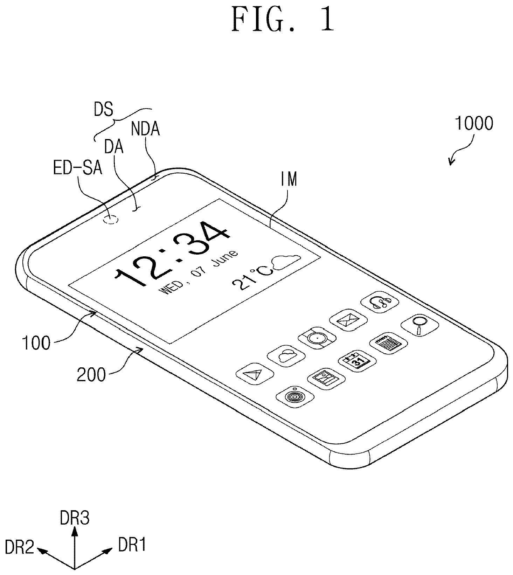

FIG. 1 is a perspective view of an electronic device according to one or more embodiments of the present invention.

An electronic device 1000 may be a device that is activated according to an electric signal. The electronic device 1000 may include one or more embodiments. For example, the electronic device 1000 may include a tablet, a laptop, a computer, a smart television, and/or the like. In one or more embodiments, the electronic device 1000 is illustrated as a smart phone as an example.

The electronic device 1000 may display an image IM in a third direction DR3 on a display surface DS parallel to a first direction DR1 and a second direction DR2. The display surface DS on which the image IM is displayed may correspond to a front surface of the electronic device 1000. The image IM may include a still image as well as a dynamic image. In FIG. 1, a watch and a plurality of icons are illustrated as an example of the image IM.

In one or more embodiments, a front surface (or an upper surface) and a rear surface (or a lower surface) of each member are defined with respect to a direction, in which the image IM is displayed. The front surface and the rear surface may be opposite to each other in the third direction DR3, and a normal direction of each of the front surface and the rear surface may be parallel to the third direction DR3. A separation distance between the front surface and the rear surface in the third direction DR3 may correspond to a thickness of the electronic device 1000 in the third direction DR3. Further, in the present disclosure, the meaning of "on a plane" may be defined as a state of "when viewed in the third direction DR3".

The display surface DS may include a display area DA and a non-display area NDA around the display area DA along an edge or periphery of the display area DA. The display area DA may display the image, and the non-display area NDA may not display the image. The non-display area NDA may surround the display area DA. However, the present invention is not limited thereto, and the shape of the display area DA and the shape of the non-display area NDA may be modified.

A sensor area ED-SA may be defined inside the display area DA of the electronic device 1000. FIG. 1 illustrates one sensor area ED-SA, but the number of sensor areas ED-SA is not limited thereto. The sensor area ED-SA may be a portion of the display area DA. Thus, the electronic device 1000 may display an image through the sensor area ED-SA.

An electronic module may be disposed in a portion overlapping the sensor area ED-SA. The electronic module may receive an external input transmitted through the sensor area ED-SA or provide an output through the sensor area ED-SA. For example, the electronic module may be a camera module, a sensor, such as a proximity sensor, which measures a distance, a sensor that recognizes a portion of a body (for example, a fingerprint, an iris, and/or a face) of a user, or a small lamp that outputs a light beam, but the present invention is not particularly limited thereto.

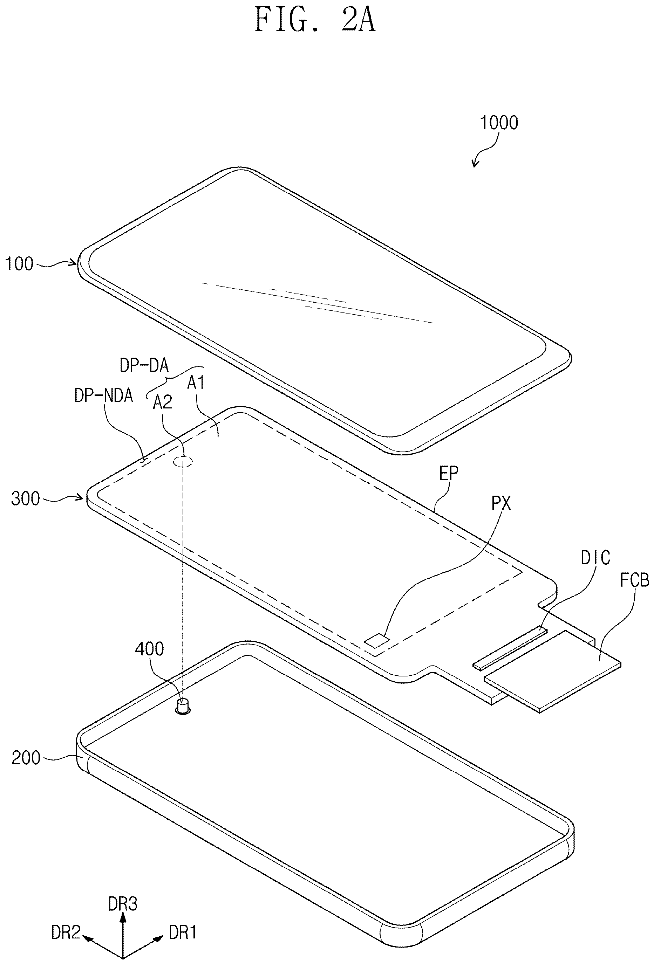

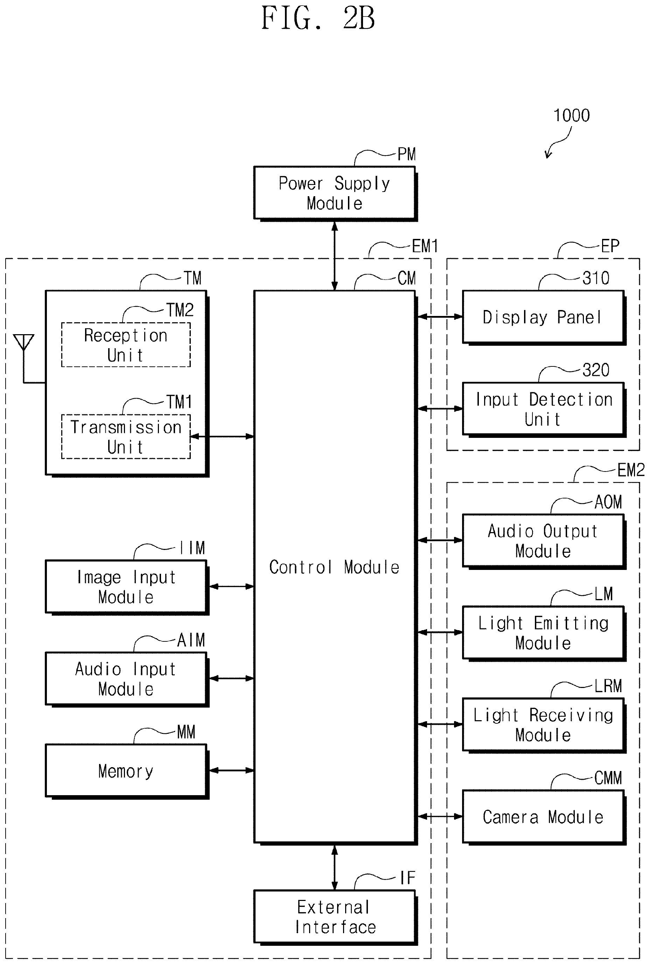

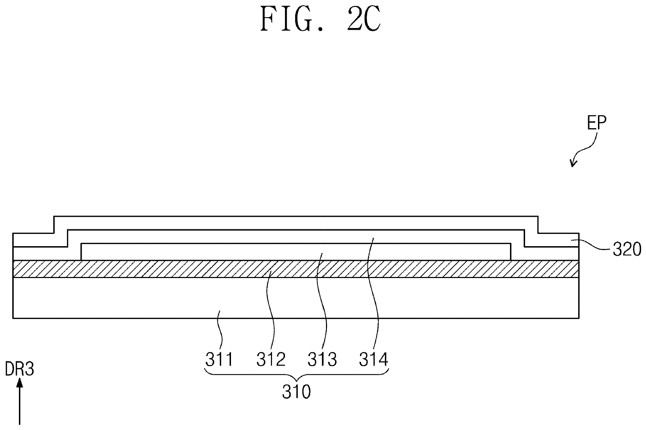

FIG. 2A is an exploded perspective view of the electronic device according to one or more embodiments of the present invention. FIG. 2B is a block diagram of the electronic device according to one or more embodiments of the present invention. FIG. 2C is a cross-sectional view of an electronic panel according to one or more embodiments of the present disclosure.

Referring to FIG. 2A, the electronic device 1000 includes a window 100, a housing 200, a display module 300, and an electronic module 400. In one or more embodiments, the window 100 and the housing 200 are coupled to each other to constitute an exterior appearance of the electronic device 1000.

The window 100 may include an insulating panel. For example, the window 100 may be made of glass, plastic, or a combination thereof. The window 100 may provide the front surface of the electronic device 1000.

The display module 300 may include at least an electronic panel EP. The electronic panel EP may generate an image and detect an external input.

The electronic panel EP includes a display area DP-DA and a non-display area DP-NDA corresponding to the display area DA (see FIG. 1) and the non-display area NDA (see FIG. 1) of the electronic device 1000, respectively. In the present disclosure, an expression "an area/part and an area/part correspond to each other" refers to that the area/part and the area/part overlap each other and is not limited to the same area.

In one or more embodiments, the electronic panel EP is assembled in a flat state, in which the display area DP-DA and the non-display area DP-NDA face the window 100. However, this is example, and a portion of the non-display area DP-NDA of the electronic panel EP may be bent. For example, the portion of the non-display area DP-NDA faces a rear surface of the electronic device 1000, and thus the non-display area NDA (see FIG. 1) illustrated on the front surface of the electronic device 1000 may be reduced. In some embodiments, the electronic panel EP may be assembled in a state, in which a portion of the display area DP-DA is bent. In some embodiments, in the electronic panel EP according to one or more embodiments of the present invention, the non-display area DP-NDA may not be provided.

The display area DP-DA may be an area, in which a plurality of pixels PX are arranged. The display area DP-DA may include a first area A1 and a second area A2. The second area A2 may overlap or correspond to the sensor area ED-SA (see FIG. 1) of the electronic device 1000. In one or more embodiments, the second area A2 has a circular shape, but may have one or more suitable shapes such as a polygon, an ellipse, a shape having at least one curved side, or an atypical shape, and the present invention is not limited to an embodiment. The first area A1 may be referred to as a main display area or a general display area, and the second area A2 may be referred to as a component area.

The second area A2 may have higher transmittance than that of the first area A1. In some embodiments, a resolution of the second area A2 may be lower than a resolution of the first area A1, but the present invention is not limited thereto. For example, the second area A2 has the higher transmittance than that of the first area A1, but the resolution of the second area A2 may be substantially the same as that of the first area A1. The second area A2 may be defined as an area overlapping with an area where the electronic module 400 is disposed inside the housing 200 in the display area DP-DA.

The first area A1 may be adjacent to the second area A2. In one or more embodiments, it is illustrated that the first area A1 has a shape around (e.g., surrounding) the entire second area A2, but this is an example. The first area A1 may be defined adjacent to only portions of edges of the second area A2, and the present invention is not limited to a particular embodiment.

Referring to FIGS. 2B and 2C, the electronic panel EP may include a display panel 310 and an input detection unit 320.

The display panel 310 may be a component that substantially generates an image. The display panel 310 may be a light emitting display panel, and for example, the display panel 310 may be an organic light emitting display panel, an inorganic light emitting display panel, a micro light emitting diode (LED) display panel, or a nano LED display panel. The display panel 310 may be referred to as a display layer.

The display panel 310 may include a base layer 311, a circuit layer 312, a light emitting element layer 313, and an encapsulation layer 314.

The base layer 311 may overlap the display area DP-DA and the non-display area DP-NDA of FIG. 2A. The base layer 311 may be a member that provides a base surface on which the circuit layer 312 is disposed. The base layer 311 may be a rigid substrate or a flexible substrate that may be bent, folded, and/or rolled. The base layer 311 may be a glass substrate, a metal substrate, a polymer substrate, and/or the like. However, one or more embodiments of the present invention are not limited thereto, and the base layer 311 may be an inorganic layer, an organic layer, and/or a composite material layer.

The base layer 311 may have a multilayer structure. For example, the base layer 311 may include a first synthetic resin layer, a multi-layer, or single-layer inorganic layer, and a second synthetic resin layer disposed on the multi-layer or single-layer inorganic layer. Each of the first and second synthetic resin layers may include a polyimide-based resin, but the present invention is not particularly limited thereto.

The circuit layer 312 may be disposed on the base layer 311. The circuit layer 312 may include an insulation layer, a semiconductor pattern, a conductive pattern, a signal line, and/or the like.

The light emitting element layer 313 may be disposed on the circuit layer 312. The light emitting element layer 313 may include a light emitting element. For example, the light emitting element may include an organic light emitting material, an inorganic light emitting material, an organic-inorganic light emitting material, a quantum dot, a quantum rod, a micro-LED, and/or a nano-LED.

The encapsulation layer 314 may be disposed on the light emitting element layer 313. The encapsulation layer 314 may protect the light emitting element layer 313 from foreign substances such as moisture, oxygen, and/or dust particles. The encapsulation layer 314 may include at least one inorganic layer. The encapsulation layer 314 may include a laminated structure of an inorganic layer/organic layer/inorganic layer.

The input detection unit 320 may be disposed on the display panel 310. The input detection unit 320 may detect an external input applied from an external unit. The external input may be an input of the user. The input of the user may include one or more suitable types (kinds) of external inputs such as a portion of the body of the user, light, heat, a pen, and/or pressure.

The input detection unit 320 may be formed on the display panel 310 through a concurrent or continuous process. In this case, the input detection unit 320 may be directly disposed on the display panel 310. Here, "directly disposed" may refer to that a third component is not disposed between the input detection unit 320 and the display panel 310. For example, a separate adhesive member may not be disposed between the input detection unit 320 and the display panel 310.

Referring back to FIG. 2A, the display module 300 may further include a driving chip DIC disposed in the non-display area DP-NDA. The display module 300 may further include a flexible circuit film FCB coupled to the non-display area DP-NDA.

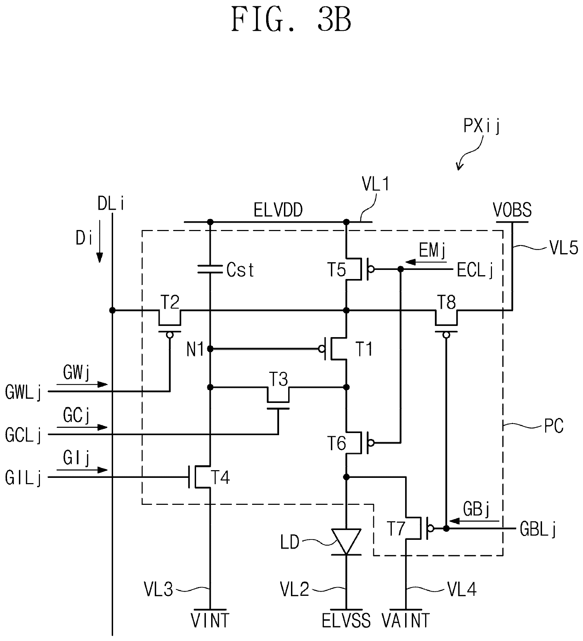

The driving chip DIC may include driving elements for driving a pixel PXij (e.g., see FIG. 3B) of the display panel 310 (see FIG. 2B), for example, a data driving circuit. Although a structure, in which the driving chip DIC is mounted on the electronic panel EP, is illustrated in FIG. 2A, the present invention is not limited thereto. For example, the driving chip DIC may be mounted on the flexible circuit film FCB.

The electronic module 400 is disposed below the display module 300. The electronic module 400 may receive an external input transmitted through the second area A2 or output a signal through the second area A2. According to the present invention, the second area A2 having relatively high transmittance is provided inside the display area DP-DA, and thus the electronic module 400 may be disposed to overlap the display area DP-DA.

Referring to FIG. 2B, the electronic device 1000 may include the display module 300 (see 2A) at least including the electronic panel EP, a power supply module PM, a first electronic module EM1, and a second electronic module EM2. The electronic panel EP, the power supply module PM, the first electronic module EM1, and the second electronic module EM2 may be electrically connected to each other.

The power supply module PM supplies power required for an overall operation of the electronic device 1000. The power supply module PM may include a general battery module.

The first electronic module EM1 and the second electronic module EM2 may include one or more suitable functional modules for operating the electronic device 1000. The first electronic module EM1 may be directly mounted on a motherboard electrically connected to the electronic panel EP or mounted on a separate substrate and thus may be electrically connected to the motherboard through a connector.

The first electronic module EM1 may include a control module CM, a wireless communication module TM, an image input module IIM, an audio input module AIM, a memory MM, and an external interface IF. Some of the modules are not mounted on the motherboard and may be electrically connected to the motherboard through a flexible circuit board.

The control module CM controls an overall operation of the electronic device 1000. The control module CM may be a micro-processor. For example, the control module CM activates or deactivates the electronic panel EP. The control module CM may control other modules such as the image input module IIM and the audio input module AIM based on a touch signal received from the electronic panel EP.

The wireless communication module TM may be to transmit/receive a wireless signal to/from another terminal utilizing a Bluetooth line and/or a Wi-Fi line. The wireless communication module TM may be to transmit and/or receive an audio signal utilizing a general communication line. The wireless communication module TM includes a transmission unit TM1 for modulating and transmitting a signal to be transmitted and a reception unit TM2 for demodulating a received signal.

The image input module IIM processes and converts an image signal into image data that may be displayed on the electronic panel EP. The audio input module AIM receives an external audio signal through a microphone in a recording mode, a voice recognition mode, and/or the like and converts the received external audio signal into electrical voice data.

The external interface IF serves as an interface connected to an external charger, a wired/wireless data port, a card socket (for example, a memory card and a subscriber identification module (SIM)/user identification module (UIM) card), and/or the like.

The second electronic module EM2 may include an audio output module AOM, a light emitting module LM, a light receiving module LRM, a camera module CMM, and/or the like. The components may be directly mounted on the motherboard or mounted on a separate substrate and electrically connected to the electronic panel EP or electrically connected to the first electronic module EM1 through the connector.

The audio output module AOM converts audio data received from the wireless communication module TM or audio data stored in the memory MM into a voice and output the converted voice to the outside.

The light emitting module LM generates and outputs a light beam. The light emitting module LM may output an infrared light beam. The light emitting module LM may include a light emitting diode (LED) element. The light receiving module LRM may detect an infrared light beam. The light receiving module LRM may be activated when the infrared light beam having a suitable level (e.g., a set or predetermined level) or higher is detected. The light receiving module LRM may include a complementary metal-oxide semiconductor (CMOS) sensor. The infrared light beam generated by the light emitting module LM may be output and then reflected by an external object (for example, a finger or face of the user), and the reflected infrared light beam may be input to the light receiving module LRM. The camera module CMM captures an external image.

According to one or more embodiments of the present invention, the electronic module 400 illustrated in FIG. 2A may include at least one of components of the second electronic module EM2. For example, the electronic module 400 may include at least one of a camera, a speaker, a light detection sensor, and/or a heat detection sensor. The electronic module 400 may detect an external input received through the second area A2 or provide a sound signal such as voice to the outside through the second area A2. Further, the electronic module 400 may include a plurality of components, and the present invention is not limited to a particular embodiment. In some embodiments, although not illustrated, the electronic module 400 may be attached to the electronic panel EP through a separate adhesive.

Referring back to FIG. 2A, the housing 200 is coupled to the window 100. The housing 200 is coupled to the window 100 to provide a suitable inner space (e.g., a set or predetermined inner space). The display module 300 and the electronic module 400 may be accommodated in the inner space.

The housing 200 may include a material having a relatively high rigidity. For example, the housing 200 may include a plurality of frames and/or plates made of glass, plastic, and/or metal and/or combinations thereof. The housing 200 may stably protect components of the electronic device 1000 accommodated in the inner space from an external impact.

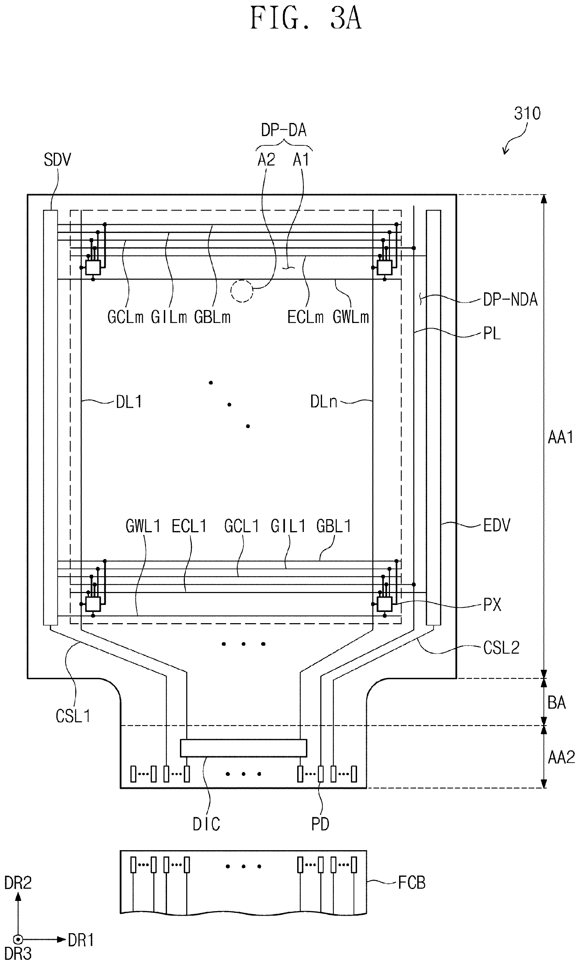

FIG. 3A is a plan view of a display panel according to one or more embodiments of the present invention.

Referring to FIG. 3A, the display area DP-DA and the non-display area DP-NDA around the display area DP-DA may be defined in the display panel 310. The display area DP-DA and the non-display area DP-NDA may be distinguished from each other depending on whether a pixel PX (also termed as pixel element herein) is disposed in that area. The pixel PX is disposed in the display area DP-DA. A scan driving unit SDV, a data driving unit, and a light emitting driving unit EDV may be arranged in the non-display area DP-NDA. The data driving unit may be a portion of a circuit included in the driving chip DIC.

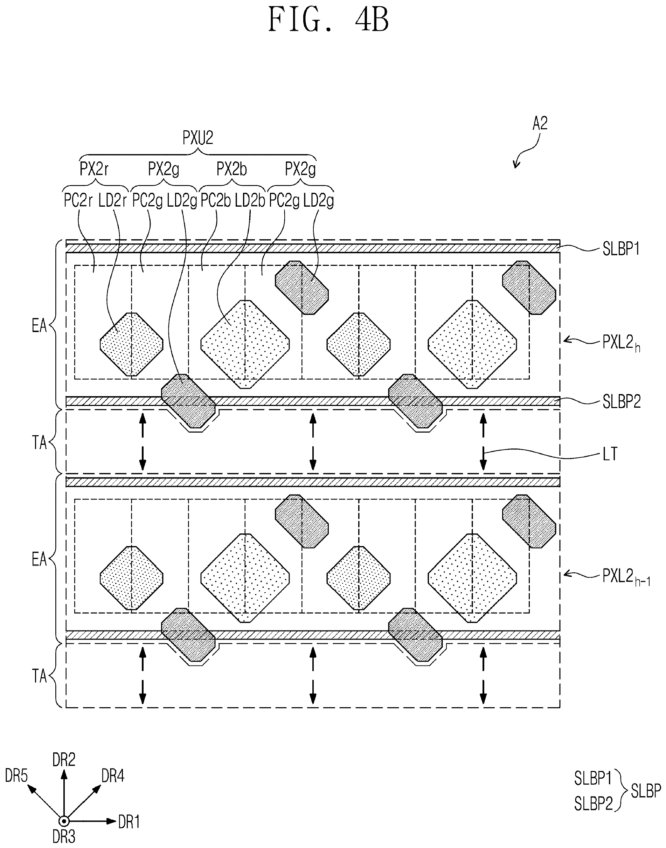

The display area DP-DA may include the first area A1 and the second area A2. The first area A1 and the second area A2 may be distinguished from each other according to an arrangement interval of the pixels PX, a size of the pixels PX, a shape of the pixels PX, or the presence or absence of a transmissive area TA (see FIG. 4B). The first area A1 and the second area A2 will be described in more detail.

The display panel 310 may include a first panel area AA1, a bending area BA, and a second panel area AA2 defined in the second direction DR2. The second panel area AA2 and the bending area BA may be partial areas of the non-display area DP-NDA. The bending area BA is disposed between the first panel area AA1 and the second panel area AA2. The first panel area AA1 is an area corresponding to the display surface DS of FIG. 1.

A width of the bending area BA and a width (or a length) of the second panel area AA2, which are parallel to the first direction DR1, may be smaller than a width (or a length) of the first panel area AA1 parallel to the first direction DR1. An area having a shorter length in a bending axis direction may be more easily bent.

The display panel 310 may include the pixels PX, writing scan lines GWL1 to GWLm, compensation scan lines GCL1 to GCLm, initialization scan lines GIL1 to GILm, black scan lines GBL1 to GBLm, light emitting control lines ECL1 to ECLm, data lines DL1 to DLn, first and second control lines CSL1 and CSL2, a driving voltage line PL, and a plurality of pads PD. In this case, "m" and "n" are natural numbers greater than or equal to two.

The pixels PX may be connected to the writing scan lines GWL1 to GWLm, the compensation scan lines GCL1 to GCLm, the initialization scan lines GIL1 to GILm, the black scan lines GBL1 to GBLm, the light emitting control lines ECL1 to ECLm, and the data lines DL1 to DLn.

The writing scan lines GWL1 to GWLm, the compensation scan lines GCL1 to GCLm, the initialization scan lines GIL1 to GILm, and the black scan lines GBL1 to GBLm may extend in the first direction DR1 and may be electrically connected to the scan driving unit SDV. The data lines DL1 to DLn may extend in the second direction DR2 and may be electrically connected to the driving chip DIC via the bending area BA. The light emitting control lines ECL1 to ECLm may extend in the first direction DR1 and may be electrically connected to the light emitting driving unit EDV.

The driving voltage line PL may include a portion extending in the first direction DR1 and a portion extending in the second direction DR2. The portion extending in the first direction DR1 and the portion extending in the second direction DR2 may be arranged in different layers. A portion of the driving voltage line PL, which extends in the second direction DR2, may extend to the second panel area AA2 via the bending area BA. The driving voltage line PL may provide a driving voltage to the pixels PX.

The first control line CSL1 may be connected to the scan driving unit SDV and may extend toward a lower end of the second panel area AA2 via the bending area BA. The second control line CSL2 may be connected to the light emitting driving unit EDV and may extend toward the lower end of the second panel area AA2 via the bending area BA.

When viewed on a plane, the pads PD may be arranged to be adjacent to the lower end of the second panel area AA2. The driving chip DIC, the driving voltage line PL, the first control line CSL1, and the second control line CSL2 may be electrically connected to the pads PD. The flexible circuit film FCB may be electrically connected to the pads PD through an anisotropic conductive adhesive layer.

FIG. 3B is an equivalent circuit diagram of a pixel according to one or more embodiments of the present invention. FIG. 3B illustrates an example equivalent circuit diagram of one pixel PXij from among the plurality of pixels PX (see FIG. 3A). Because the plurality of pixels PX (see FIG. 3A) have the same circuit structure, a detailed description of the other pixels PX (see FIG. 3A) will not be provided because a description of a circuit structure of the pixel PXij is present.

Referring to FIG. 3B, the pixel PXij is connected to an i^{th} data line DLi from among the data lines DL1 to DLn (see FIG. 3A), a j^{th} writing scan line GWLj from among the writing scan lines GWL1 to GWLm (see FIG. 3A), a j^{th} compensation scan line GCLj from among the compensation scan lines GCL1 to GCLm (see FIG. 3A), a j^{th} initialization scan line GILj from among the initialization scan lines GIL1 to GILm (see FIG. 3A), a j^{th} black scan line GBLj from among the black scan lines GBL1 to GBLm (see FIG. 3A), a j^{th} light emitting control line ECLj from among the light emitting control lines ECL1 to ECLm (see FIG. 3A), first and second driving voltage lines VL1 and VL2, first and second initialization voltage lines VL3 and VL4, and a bias voltage line VL5. In this case, "i" is an integer greater than or equal to 1 and less than or equal to n, and "j" is an integer greater than or equal to 1 and less than or equal to m.

The pixel PXij may include a pixel circuit PC and a light emitting element LD connected to the pixel circuit PC. The light emitting element LD may be a light emitting diode. As an example of the present invention, the light emitting element LD may be an organic light emitting diode including an organic light emitting layer, but the present invention is not particularly limited thereto. The pixel circuit PC may drive the light emitting element LD. The pixel circuit PC may be referred to as a pixel driving circuit. The pixel circuit PC may control the amount of a current flowing in the light emitting element LD in response to an i^{th} data signal Di. The light emitting element LD may be to emit a light beam having a suitable luminance (e.g., a set or predeterminedluminance) to correspond to the amount of current provided from the pixel circuit PC. In the present invention, the amount of current of the pixel PXij may be the amount of current provided to the light emitting element LD.

The pixel circuit PC may include a plurality of transistors T1 to T8 and a capacitor Cst. According to the present invention, a configuration of the pixel circuit PC is not limited to an embodiment illustrated in FIG. 3B. The pixel circuit PC illustrated in FIG. 3B is merely an example and a configuration of the pixel circuit PC may be modified and implemented.

At least one of the first to eighth transistors T1, T2, T3, T4, T5, T6, T7, and T8 may be a transistor having a low-temperature polycrystalline silicon (LTPS) semiconductor layer. At least one of the first to eighth transistors T1, T2, T3, T4, T5, T6, T7, and T8 may be a transistor having an oxide semiconductor layer. For example, the third and fourth transistors T3 and T4 may be oxide semiconductor transistors, and the first, second, fifth, sixth, seventh, and eighth transistors T1, T2, T5, T6, T7, and T8 may be LTPS transistors.

In detail, the first transistor T1 (or referred to as a driving transistor), which directly affects the brightness of the light emitting element LD, includes a highly reliable polycrystalline silicon semiconductor layer, and therefore, a high-resolution display device may be implemented. In one or more embodiments, because the oxide semiconductor has high carrier mobility and a low leakage current, a voltage drop is not large even when a driving time is long. For example, because a change in a color of the image due to the voltage drop is not large even during low-frequency driving, the low-frequency driving may be performed. In this way, because the oxide semiconductor has a low leakage current, at least one from among the third transistor T3 and the fourth transistor T4 connected to a gate electrode of the first transistor T1 may usethe oxide transistor, and thus leakage current that may flow to the gate electrode may be prevented or reduced, and at the same time, power consumption may be reduced.

Some of the first to eighth transistors T1, T2, T3, T4, T5, T6, T7, and T8 may be P-type or kind transistors and the other thereof may be N-type or kind transistors. For example, the first, second, fifth, sixth, seventh, and eighth transistors T1, T2, T5, T6, T7, and T8 may be P-type or kind transistors, and the third and fourth transistors T3 and T4 may be N-type or kind transistors.

A configuration of the pixel circuit PC according to the present invention is not limited to an embodiment illustrated in FIG. 3B. The pixel circuit PC illustrated in FIG. 3B is merely an example, and a configuration of the pixel circuit PC may be modified and implemented. For example, all the first to eighth transistors T1, T2, T3, T4, T5, T6, T7, and T8 may be P-type or kind transistors or N-type or kind transistors.

The j^{th} writing scan line GWLj, the j^{th} compensation scan line GCLj, the j^{th} initialization scan line GILj, the j^{th} black scan line GBLj, and the j^{th} light emitting control line ECLj may be to transmit, to the pixel PXij, a j^{th} writing scan signal GWj, a j^{th} compensation scan signal GCj, a j^{th} initialization scan signal Glj, a j^{th} black scan signal GBj, and a j^{th} light emitting control signal EMj, respectively. The i^{th} data line DLi transmits an i^{th} data signal Di to the pixel PXij. The i^{th} data signal Di may have a voltage level corresponding to an image signal input to the electronic panel EP (see FIG. 2A).

The first and second driving voltage lines VL1 and VL2 may be to transmit, to the pixel PXij, a first driving voltage ELVDD and a second driving voltage ELVSS, respectively. Further, the first and second initialization voltage lines VL3 and VL4 may be to transmit, to the pixel PXij, a first initialization voltage VINT and a second initialization voltage VAINT, respectively. The bias voltage line VL5 may be to transmit a bias voltage VOBS to the pixel PXij.

The first transistor T1 is connected between the first driving voltage line VL1 that receives the first driving voltage ELVDD and the light emitting element LD. The first transistor T1 includes a first electrode connected to the first driving voltage line VL1 via the fifth transistor T5, a second electrode connected to a pixel electrode (or referred to as an anode) of the light emitting element LD via the sixth transistor T6, and a third electrode (for example, a gate electrode) connected to one end (for example, a first node N1) of the capacitor Cst. The first transistor T1 may receive the i^{th} data signal Di transmitted by the i^{th} data line DLi according to a switching operation of the second transistor T2 and supply a driving current to the light emitting element LD.

The second transistor T2 is connected between the data line DLi and the first electrode of the first transistor T1. The second transistor T2 includes a first electrode connected to the data line DLi, a second electrode connected to the first electrode of the first transistor T1, and a third electrode (for example, a gate electrode) connected to the j^{th} writing scan line GWLj. The second transistor T2 may be turned on according to the j^{th} writing scan signal GWj transmitted through the j^{th} writing scan line GWLj and may be to transmit the i^{th} data signal Di transmitted from the i^{th} data line DLi to the first electrode of the first transistor T1.

The third transistor T3 is connected between the second electrode of the first transistor T1 and the first node N1. The third transistor T3 includes a first electrode connected to the third electrode of the first transistor T1, a second electrode connected to the second electrode of the first transistor T1, and a third electrode (for example, a gate electrode) connected to the j^{th} compensation scan line GCLj. The third transistor T3 may be turned on according to the j^{th} compensation scan signal GCj transmitted through the j^{th} compensation scan line GCLj, may connect the third electrode of the first transistor T1 and the second electrode of the first transistor T1 to each other, and thus may diode-connect the first transistor T1.

The fourth transistor T4 is connected between the first initialization voltage line VL3 to which the first initialization voltage VINT is applied and the first node N1. The fourth transistor T4 includes a first electrode connected to the first initialization voltage line VL3 to which the first initialization voltage VINT is transmitted, a second electrode connected to the first node N1, and a third electrode (for example, a gate electrode) connected to the j^{th} initialization scan line GILj. The fourth transistor T4 is turned on according to the j^{th} initialization scan signal Glj transmitted through the j^{th} initialization scan line GILj. The turned-on fourth transistor T4 transmits the first initialization voltage VINT to the first node N1 and initializes a potential of the third electrode of the first transistor T1 (that is, a potential of the first node N1).

The fifth transistor T5 includes a first electrode connected to the first driving voltage line VL1, a second electrode connected to the first electrode of the first transistor T1, and a third electrode (for example, a gate electrode) connected to the j^{th} light emitting control line ECLj. The sixth transistor T6 includes a first electrode connected to the second electrode of the first transistor T1, a second electrode connected to the pixel electrode of the light emitting element LD, and a third electrode (for example, a gate electrode) connected to the j^{th} light emitting control line ECLj.

The fifth and sixth transistors T5 and T6 are concurrently (e.g., simultaneously) turned on according to the j^{th} light emitting control signal EMj transmitted through the j^{th} light emitting control line ECLj. The first driving voltage ELVDD applied through the turned on fifth transistor T5 may be compensated for through the diode-connected first transistor T1 and then may be transmitted to the light emitting element LD through the sixth transistor T6.

The seventh transistor T7 includes a first electrode connected to the second initialization voltage line VL4 to which the second initialization voltage VAINT is applied, a second electrode connected to the second electrode of the sixth transistor T6, and a third electrode (for example, a gate electrode) connected to the j^{th} black scan line GBLj. The second initialization voltage VAINT may have a voltage level lower than or equal to the first initialization voltage VINT. The seventh transistor T7 may improve black expression capability of the pixel PXij. When the seventh transistor T7 is turned on, a parasitic capacitor of the light emitting element LD may be discharged. Thus, when black luminance is implemented, the light emitting element LD does not emit a light beam due to a leakage current of the first transistor T1, and accordingly, the black expression capability may be improved.

One end of the capacitor Cst is connected to the third electrode of the first transistor T1, and the other end of the capacitor Cst is connected to the first driving voltage line VL1. A cathode of the light emitting element LD may be connected to the second driving voltage line VL2 that transmits the second driving voltage ELVSS. The second driving voltage ELVSS may have a voltage level lower than that of the first driving voltage ELVDD. When the fifth transistor T5 and the sixth transistor T6 are turned on, the amount of current flowing through the first transistor T1 may be determined according to a voltage stored in the capacitor Cst.

The eighth transistor T8 may include a first electrode connected to the bias voltage line VL5, a second electrode connected to the first electrode of the first transistor T1, and a control electrode connected to the j^{th} black scan line GBLj. The eighth transistor T8 is turned on by the j^{th} black scan signal GBj and may provide the bias voltage VOBS to the first electrode of the first transistor T1. When the bias voltage VOBS is applied to the first transistor T1, movement of a hysteresis curve of the first transistor T1 may be suppressed or reduced.

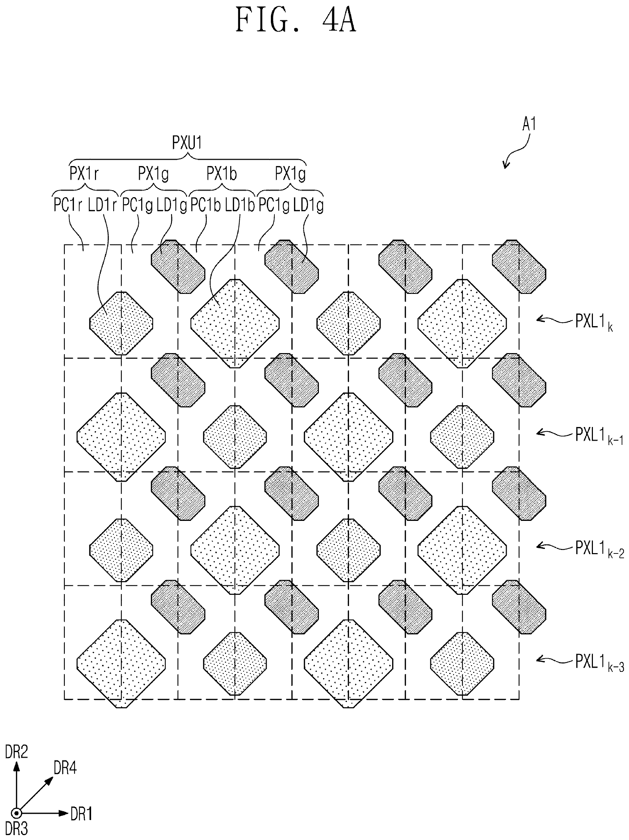

FIG. 4A is an enlarged plan view of a portion of the display area according to one or more embodiments of the present invention. FIG. 4A illustrates a portion of the first area A1 of the display area DP-DA (see FIG. 2A) in an enlarged manner and illustrates an arrangement of the pixels PX (see FIG. 2A) in the first area A1.

FIG. 4A illustrates four first pixel rows PXL1ₖ, PXL1ₖ₋₁, PXL1ₖ₋₂, and PXL1ₖ₋₃ in the first area A1 in an enlarged manner. Referring to FIG. 4A, in the k^{th} first pixel row PXL1ₖ, one (1-1)^{th} color pixel PX1r, two (2-1)^{th} color pixels PX1g, and one (3-1)^{th} color pixel PX1b may constitute one first pixel group PXU1. In the one first pixel group PXU1, the (1-1)^{th} color pixel PX1r, the (2-1)^{th} color pixel PX1g, the (3-1)^{th} color pixel PX1b, and the (2-1)^{th} color pixel PX1g may be arranged along the first direction DR1.

The (1-1)^{th} color pixel to the (3-1)^{th} color pixel PX1r, PX1g, and PX1b may include pixel circuits PC1r, PC1g, and PC1b and light emitting elements LD1r, LD1g, and LD1b, respectively. In FIG. 4A, the pixel circuits PC1r, PC1g, and PC1b are illustrated by dotted lines. FIG. 4A illustrates an area of an anode of each of the light emitting elements LD1r, LD1g, and LD1b, which is exposed by a light emitting opening which will be described. A portion of the anode of the light emitting element LD1r, LD1g, and LD1b, which is exposed by the light emitting opening which will be described, may be defined as a light emitting area, and the light emitting area may correspond to an area, in which a light beam provided from the light emitting element LD1r, LD1g, and LD1b is emitted.

The (1-1)^{th} color pixel PX1r may include the (1-1)^{th} pixel circuit PC1r and the (1-1)^{th} light emitting element LD1r, and the (1-1)^{th} light emitting element LD1r may be configured to emit a light beam having a first color to a first light emitting area. The (2-1)^{th} color pixel PX1g may include the (2-1)^{th} pixel circuit PC1g and the (2-1)^{th} light emitting element LD1g, and the (2-1)^{th} light emitting element LD1g may be configured to emit a light beam having a second color different from the first color to a second light emitting area. The (3-1)^{th} color pixel PX1b may include the (3-1)^{th} pixel circuit PC1b and the (3-1)^{th} light emitting element LD1b, and the (3-1)^{th} light emitting element LD1b may be configured to emit a light beam having a third color different from the first color and the second color to a third light emitting area. In one or more embodiments, the light beam having the first color may be a red light beam, the light beam having the second color may be a green light beam, and the light beam having the third color may be a blue light beam.

In the one first pixel group PXU1, the (1-1)^{th} pixel circuit PC1r, the (2-1)^{th} pixel circuit PC1g, the (3-1)^{th} pixel circuit PC1b, and the (2-1)^{th} pixel circuit PC1g may be arranged side by side along the first direction DR1.

In the one first pixel group PXU1, the (1-1)^{th} light emitting element LD1r and the (3-1)^{th} light emitting element LD1b may be spaced from each other in the first direction DR1, and the two (2-1)^{th} light emitting elements LD1g may be spaced from each other in the first direction DR1. In the one first pixel group PXU1, the two (2-1)^{th} light emitting elements LD1g may be spaced from the (1-1)^{th} light emitting element LD1r and the (3-1)^{th} light emitting element LD1b in a fourth direction DR4. The fourth direction DR4 (e.g., a diagonal direction) may be a direction crossing the first direction DR1 and the second direction DR2 on a plane defined by the first direction DR1 and the second direction DR2.

In a k^{th} first pixel row PXL1ₖ, the first pixel groups PXU1 may be repeatedly arranged along the first direction DR1. Even in (k-1)^{th}, (k-2)^{th}, and (k-3)^{th} first pixel rows PXL1ₖ₋₁, PXL1ₖ₋₂, and PXL1ₖ₋₃, the first pixel groups PXU1 may be repeatedly arranged along the first direction DR1.

The first pixel groups PXU1 of the k^{th} first pixel row PXL1ₖ and the first pixel groups PXU1 of the (k-2)^{th} first pixel row PXL1ₖ₋₂ may be repeatedly arranged along the second direction DR2. In one or more embodiments, in the (k-1)^{th} and (k-3)^{th} first pixel rows PXL1ₖ₋₁ and PXL1ₖ₋₃, the first pixel groups PXU1 may be partially shifted in the first direction DR1 as compared to the k^{th} and (k-2)^{th} first pixel rows PXL1ₖ and PXL1ₖ₋₂. Accordingly, the (1-1)^{th} light emitting elements LD1r and the (3-1)^{th} light emitting elements LD1b may be alternately arranged along the second direction DR2.

FIG. 4B is an enlarged plan view of a portion of the display area according to one or more embodiments of the present invention. FIG. 4B illustrates a portion of the second area A2 of the display area DP-DA (see FIG. 2A) in an enlarged manner and illustrates an arrangement of the pixels PX (see FIG. 2A) in the second area A2.

Referring to FIG. 4B, the second area A2 may include an element area EA and the transmissive area TA. In the second area A2, the element area EA and the transmissive area TA may extend in the first direction DR1, and the element area EA and the transmissive area TA may be alternately arranged along the second direction DR2.

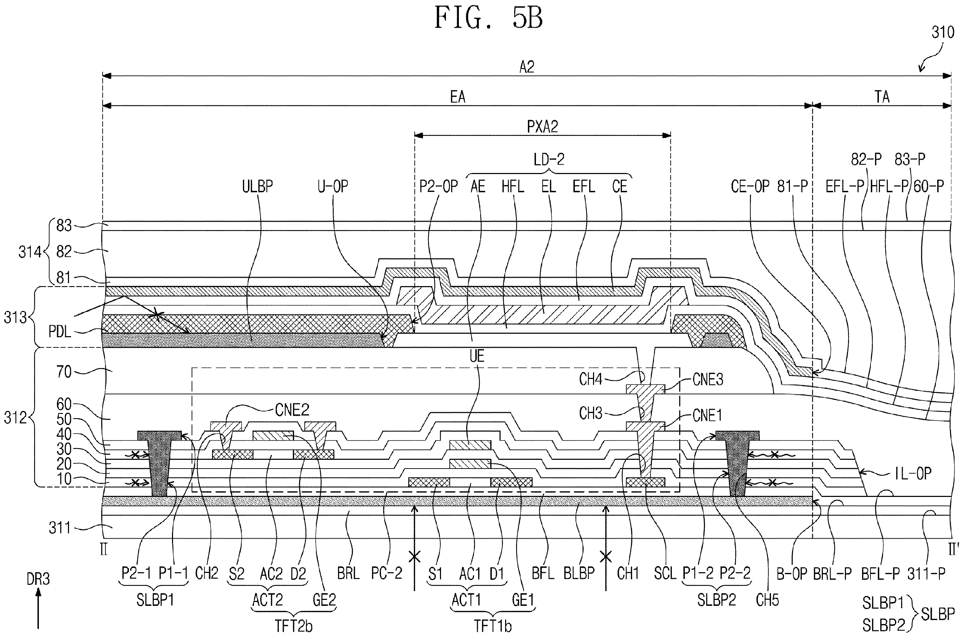

The element area EA may be an area, in which conductive materials constituting the pixel PX (see FIG. 2A) are patterned. Transmittance of the transmissive area TA may be higher than that of the element area EA. In one or more embodiments, the element area EA may be entirely covered by a lower light shielding pattern BLBP (see FIG. 5B), which will be described.

FIG. 4B illustrates, as an example, the two element areas EA and the two transmissive areas TA that are alternately arranged. One second pixel row may be disposed in each of the two element areas EA. Accordingly, FIG. 4B illustrates two second pixel rows PXL2ₕ and PXL2ₕ₋₁ in an enlarged manner.

In the h^{th} second pixel row PXL2ₕ, one (1-2)^{th} color pixel PX2r, two (2-2)^{th} color pixels PX2g, and one (3-2)^{th} color pixel PX2b may constitute one second pixel group PXU2. In the one second pixel group PXU2, the (1-2)^{th} color pixel PX2r, the (2-2)^{th} color pixel PX2g, the (3-2)^{th} color pixel PX2b, and the (2-2)^{th} color pixel PX2g may be arranged along the first direction DR1.

The (1-2)^{th} color pixel to the (3-2)^{th} color pixel PX2r, PX2g, and PX2b may include pixel circuits PC2r, PC2g, and PC2b and light emitting elements LD2r, LD2g, and LD2b, respectively. In FIG. 4B, the pixel circuits PC2r, PC2g, and PC2b are illustrated by dotted lines. FIG. 4B illustrates an area of an anode of each of the light emitting elements LD2r, LD2g, and LD2b, which is exposed by the light emitting opening which will be described. The area of the anode of the light emitting element, which is exposed by the light emitting opening which will be described, may be defined as a light emitting area, and the light emitting area may correspond to an area, in which a light beam provided from the light emitting element LD2r, LD2g, and LD2b is emitted.

The (1-2)^{th} color pixel PX2r may include the (1-2)^{th} pixel circuit PC2r and the (1-2)^{th} light emitting element LD2r, and the (1-2)^{th} light emitting element LD2r may be configured to emit a light beam having the first color to the first light emitting area. The (2-2)^{th} color pixel PX2g may include the (2-2)^{th} pixel circuit PC2g and the (2-2)^{th} light emitting element LD2g, and the (2-2)^{th} light emitting element LD2g may be configured to emit a light beam having the second color different from the first color to the second light emitting area. The (3-2)^{th} color pixel PX2b may include the (3-2)^{th} pixel circuit PC2b and the (3-2)^{th} light emitting element LD2b, and the (3-2)^{th} light emitting element LD2b may be configured to emit a light beam having the third color different from the first color and the second color to the third light emitting area.

In the one second pixel group PXU2, the (1-2)^{th} pixel circuit PC2r, the (2-2)^{th} pixel circuit PC2g, the (3-2)^{th} pixel circuit PC2b, and the (2-2)^{th} pixel circuit PC2g may be arranged side by side along the first direction DR1.

In the one second pixel group PXU2, the (1-2)^{th} light emitting element LD2r and the (3-2)^{th} light emitting element LD2b may be spaced from each other in the first direction DR1. One of the two (2-2)^{th} light emitting elements LD2g may be spaced from the (1-2)^{th} light emitting element LD2r in a fifth direction DR5 (e.g., a diagonal direction). The fifth direction DR5 may be a direction crossing the first direction DR1, the second direction DR2, and the fourth direction DR4 on a plane defined by the first direction DR1 and the second direction DR2. The other one of the two (2-2)^{th} light emitting elements LD2g may be spaced from the (3-2)^{th} light emitting element LD2b in the fourth direction DR4. The two (2-2)^{th} light emitting elements LD2g may be spaced (e.g., apart) from each other in the fourth direction DR4 with the (3-2)^{th} light emitting element LD2b interposed therebetween.

In the h^{th} second pixel row PXL2ₕ, the second pixel groups PXU2 may be repeatedly arranged with each other along the first direction DR1. In the (h-1)^{th} second pixel row PXL2ₕ₋₁, the second pixel groups PXU2 may be repeatedly arranged with each other along the first direction DR1.

Referring to FIGS. 4A and 4B together, the pixel arrangement in the second area A2 may be formed by removing some pixels from the pixel arrangement in the first area A1. Therefore, the second area A2 may have higher transmittance than that of the first area A1. In one or more embodiments of the present invention, the pixel arrangement in the second area A2 may be formed by removing some pixels from the first pixel rows adjacent to each other in the first area A1 (hereinafter, described based on the k^{th} first pixel row PXL1ₖ and (k-1)^{th} first pixel row PXL1ₖ₋₁).

The arrangement of the pixel circuits in the second area A2 may be selected as the pixel circuits in the k^{th} first pixel row PXL1ₖ. In other words, the arrangement of the pixel circuits in the second area A2 may be obtained by removing the pixel circuits from the (k-1)^{th} first pixel row PXL1ₖ₋₁. The arrangement of the (1-2)^{th}, (2-2)^{th}, and (3-2)^{th} pixel circuits PC2r, PC2g, and PC2b arranged in the h^{th} second pixel row PXL2ₕ may be the same as the arrangement of the (1-1)^{th}, (2-1)^{th}, and (3-1)^{th} pixel circuits PC1r, PC1g, and PC1b arranged in the k^{th} first pixel row PXL1ₖ.

The arrangement of the light emitting elements in the second area A2 may be selected as some of the light emitting elements in the k^{th} first pixel row PXL1ₖ and some of the light emitting elements in the (k-1)^{th} first pixel row PXL1ₖ₋₁. For example, in the arrangement of the light emitting elements of the h^{th} second pixel row PXL2ₕ, some of the (1-1)^{th} light emitting elements LD1r, the (3-1)^{th} light emitting elements LD1b, and the (2-1)^{th} light emitting elements LD1g of the k^{th} first pixel row PXL1ₖ may be selected, and some of the (2-1)^{th} light emitting elements LD1g of the (k-1)^{th} first pixel row PX1ₖ₋₁ may be selected. In other words, some of the (2-1)^{th} light emitting elements LD1g of the k^{th} first pixel row PXL1ₖ are removed, and some of the (2-1)^{th} light emitting elements LD1g, the (1-1)^{th} light emitting elements LD1r, and the (3-1)^{th} light emitting elements LD1b of the (k-1)^{th} first pixel row PXL1ₖ₋₁ are removed.

The (2-2)^{th} light emitting elements LD2g in the h^{th} second pixel row PXL2ₕ may be the same as a state, in which the (2-1)^{th} light emitting elements LD1g selected from the k^{th} first pixel row PXL1ₖ and the (2-1)^{th} light emitting elements LD1g selected from the (k-1)^{th} first pixel row PXL1ₖ₋₁ are alternately arranged. The selection and removal of the (2-1)^{th} light emitting elements LD1g in the k^{th} first pixel row PXL1ₖ may be repeated in units of one pixel group, and the selection and removal of the (2-1)^{th} light emitting elements LD1g in the (k-1)^{th} first pixel row PXL1ₖ₋₁ may also be repeated in units of one pixel group.

In one or more embodiments, a side light shielding pattern SLBP may be disposed in the second area A2. The side light shielding pattern SLBP may be disposed inside the element area EA.

The side light shielding pattern SLBP may include a first side pattern SLBP1 and a second side pattern SLBP2. Each of the first side pattern SLBP1 and the second side pattern SLBP2 may extend in the first direction DR1. The first side pattern SLBP1 and the second side pattern SLBP2 may be spaced from each other in the second direction DR2 with the pixel circuits interposed therebetween, the pixel circuits being arranged in the h^{th} second pixel row PXL2ₕ. Each of the first side pattern SLBP1 and the second side pattern SLBP2 may continuously extend along the pixel circuits PC2r, PC2g, and PC2b arranged in the h^{th} second pixel row PXL2ₕ.

A plurality of side light shielding patterns SLBP may be provided and arranged in each of the element areas EA. As illustrated in FIG. 4B, the side light shielding pattern SLBP may also be disposed inside the element area EA, in which the (h-1)^{th} second pixel row PXL2ₕ₋₁ is disposed.

A portion of a light beam LT (e.g., an infrared light beam) emitted from the electronic module 400 (see FIG. 2A) may be provided to the transmissive area TA and reflected and/or transmitted toward the element area EA. However, according to the present invention, the light beam LT emitted from the electronic module 400 (see FIG. 2A) through the side light shielding pattern SLBP may be restrained or prevented or reduced from being introduced into the pixel circuits PC2r, PC2g, and PC2b in the second pixel row. A detailed description thereof will be made.

In one or more embodiments, FIGS. 4A and 4B illustrate an example arrangement form of the pixel circuits and the light emitting areas, but the present invention is not limited thereto, and the pixel circuits and the light emitting areas may be arranged in one or more suitable forms. Further, it is illustrated as an example that the arrangement form of the pixel circuits and the light emitting areas of FIG. 4B is obtained by partially removing a portion of the arrangement form of the pixel circuits and the light emitting areas of FIG. 4A, but the present invention is not limited thereto. For example, the arrangement form of the pixel circuits and the light emitting areas of FIG. 4A and the arrangement form of the pixel circuits and the light emitting areas of FIG. 4B may be adopted independently of each other.

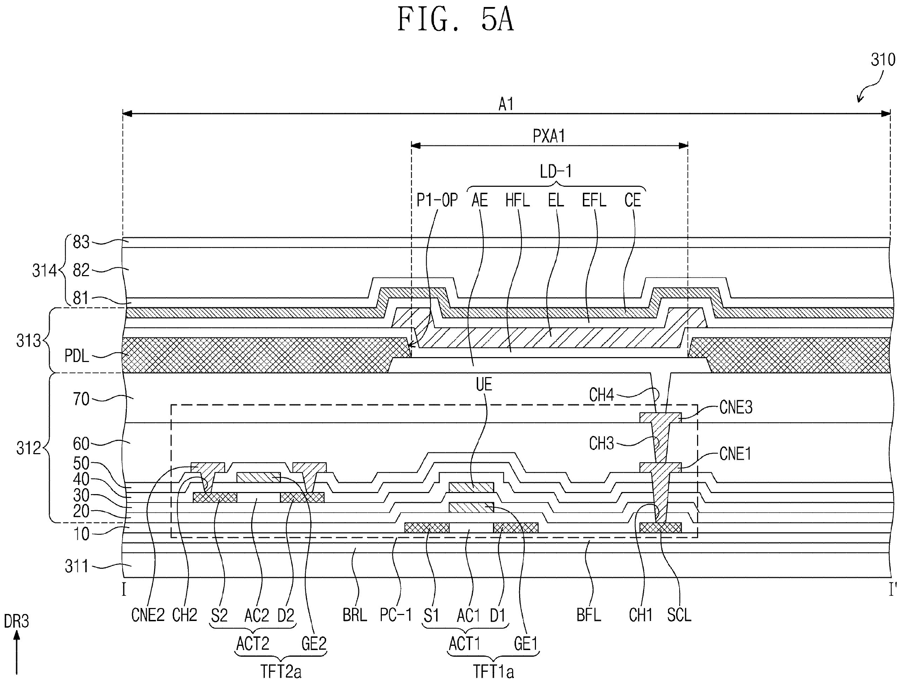

FIG. 5A is a cross-sectional view illustrating the first area of the display panel according to one or more embodiments of the present invention. FIG. 5B is a cross-sectional view illustrating the second area of the display panel according to one or more embodiments of the present invention. The same/similar reference numerals are utilized for the same/similar components described in FIGS. 1 to 4B, and a duplicated description thereof will not be provided.

Referring to FIGS. 5A and 5B, the display panel 310 according to one or more embodiments may include the base layer 311, a barrier layer BRL, the lower light shielding pattern BLBP, a buffer layer BFL, the circuit layer 312, the light emitting element layer 313, and the encapsulation layer 314.

In one or more embodiments of the present invention, it may be seen that the first area A1 and the element area EA and the transmissive area TA included in the second area A2 are defined in the base layer 311, and in this case, it may be seen that components arranged on the base layer 311 are arranged to overlap the first area A1, the element area EA, and/or the transmissive area TA.

The barrier layer BRL may be disposed on the base layer 311. The barrier layer BRL may include an inorganic material. For example, the barrier layer BRL may include at least one of silicon oxide, aluminum oxide, titanium oxide, silicon nitride, silicon oxy nitride, zirconium oxide, and/or hafnium oxide.

In one or more embodiments, as illustrated in FIG. 5B, the lower light shielding pattern BLBP may be disposed in the element area EA of the second area A2. The lower light shielding pattern BLBP may overlap the element area EA of the second area A2 and may not overlap at least a portion of the transmissive area TA. In one or more embodiments, the lower light shielding pattern BLBP may be disposed to entirely overlap the element area EA.

The lower light shielding pattern BLBP may be disposed on the barrier layer BRL so that a problem, in which conductive materials arranged on the base layer 311 and the barrier layer BRL are visually recognized in the element area EA by an external light beam, may be solved. Accordingly, even when the electronic module 400 (see FIG. 2A) is disposed inside the display area DA (see FIG. 1), as interference with conductive materials arranged on the base layer 311 and the barrier layer BRL is reduced or minimized, the electronic device 1000 (see FIG. 1), in which performance of the electronic module 400 (see FIG. 2A) is improved, may be provided.

Further, the lower light shielding pattern BLBP may prevent or reduce the light beam (e.g., the infrared light beam) emitted from the electronic module 400 (see FIG. 2A) from reaching transistors arranged on the base layer 311 and the barrier layer BRL.

FIG. 5A is an example which illustrates that the lower light shielding pattern BLBP is not disposed in the first area A1, but the lower light shielding pattern BLBP may be disposed inside the first area A1. In one or more embodiments, the lower light shielding pattern BLBP may entirely overlap the first area A1 and/or may overlap at least some transistors.

The buffer layer BFL may be disposed on the barrier layer BRL and the lower light shielding pattern BLBP. The buffer layer BFL may prevent or reduce metal atoms or impurities from being diffused from the base layer 311 to the semiconductor pattern. Further, the buffer layer BFL may adjust a heat supply rate during a crystallization process for forming the semiconductor pattern, so that the semiconductor pattern may be uniformly formed.

The buffer layer BFL may include a plurality of inorganic layers. For example, the buffer layer BFL may include a first sub-buffer layer containing silicon nitride and a second sub-buffer layer disposed on the first sub-buffer layer and containing silicon oxide. The buffer layer BFL may be referred to as a lower insulating layer.

The circuit layer 312 may be disposed on the buffer layer BFL, and the light emitting element layer 313 may be disposed on the circuit layer 312.

FIG. 5A is a cross-sectional view of portions of a light emitting element (hereinafter, referred to as a first light emitting element LD-1) and a pixel circuit (hereinafter, referred to as a first pixel circuit PC-1) arranged in the first area A1. The first light emitting element LD-1 and the first pixel circuit PC-1 of FIG. 5A may correspond to a light emitting element and a pixel circuit of any one of the (1-1)^{th} color pixel PX1r, the (2-1)^{th} color pixel PX1g, and the (3-1)^{th} color pixel PX1b of FIG. 4A.

FIG. 5B is a cross-sectional view of portions of a light emitting element (hereinafter, referred to as a second light emitting element LD-2) and a pixel circuit (hereinafter, referred to as a second pixel circuit PC-2) arranged in the second area A2. The second light emitting element LD-2 and the second pixel circuit PC-2 of FIG. 5B may correspond to a light emitting element and a pixel circuit of any one of the (1-2)^{th} color pixel PX2r, the (2-2)^{th} color pixel PX2g, and the (3-2)^{th} color pixel PX2b of FIG. 4B.

FIG. 5A illustrates, as an example, a first type or kind transistor TFT1a and a second type or kind transistor TFT2a of the first pixel circuit PC-1. FIG. 5B illustrates a first type or kind transistor TFT1b and a second type or kind transistor TFT2b of the second pixel circuit PC-2. In one or more embodiments, the first type or kind transistors TFT1a and TFT1b may be silicon thin film transistors, and the second type or kind transistors TFT2a and TFT2b may be oxide thin film transistors. The first type or kind thin film transistors TFT1a and TFT1b may be one of the first, second, fifth, sixth, seventh, and eighth transistors T1, T2, T5, T6, T7, and T8 described in FIG. 3B, and the second type or kind thin film transistors TFT2a and TFT2b may be one of the third and fourth transistors T3 and T4. In one or more embodiments, the first type or kind transistors TFT1a and TFT1b and the second type or kind transistors TFT2a and TFT2b may be arranged in different layers.

Semiconductor patterns (hereinafter, referred to as a first semiconductor pattern ACT1) of the first type or kind transistors TFT1a and TFT1b may be arranged on the buffer layer BFL. The first semiconductor pattern ACT1 may include a silicon semiconductor. For example, the silicon semiconductor may include amorphous silicon, polycrystalline silicon, and/or the like. For example, the first semiconductor pattern ACT1 may include a low-temperature polysilicon.

FIGS. 5A and 5B merely illustrate a portion of the first semiconductor pattern ACT1 disposed on the buffer layer BFL, and the first semiconductor pattern ACT1 may be further disposed in another area. The first semiconductor pattern ACT1 may be disposed in a specific arrangement (e.g., rule) across the pixels PX (see FIG. 2A). The first semiconductor pattern ACT1 may have different electrical properties depending on whether the first semiconductor pattern ACT1 is doped. The first semiconductor pattern ACT1 may include a first area having higher conductivity and a second area having lower conductivity. The first area may be doped with an N-type or kind dopant or a P-type or kind dopant. A P-type or kind transistor may include a doping area doped with the P-type or kind dopant, and an N-type or kind transistor may include a doping area doped with the N-type or kind dopant. The second area may be a non-doping area or may be an area doped at a concentration lower than a concentration of the first area.

A conductivity of the first area is greater than a conductivity of the second area, and the first area may substantially serve as an electrode or a signal line. The second area may substantially correspond to active areas (or a channel) of the first type or kind transistors TFT1a and TFT1b. In other words, a portion of the first semiconductor pattern ACT1 may be active areas of the first type or kind transistors TFT1a and TFT1b, another portion thereof may be source areas or drain areas of the first type or kind transistors TFT1a and TFT1b, and still another portion thereof may be a connection electrode or a connection signal line.

A source area S1, an active area AC1, and a drain area D1 of the first type or kind transistors TFT1a and TFT1b may be formed from the first semiconductor pattern ACT1. The source area S1 and the drain area D1 may extend from the active area AC1 in opposite directions in a cross section.

A connection signal line SCL may be disposed on the buffer layer BFL. The connection signal line SCL may be connected to a drain area of the sixth transistor T6 (see FIG. 3B) on a plane.

The circuit layer 312 may include a plurality of inorganic layers and a plurality of organic layers. In one or more embodiments, first to fifth insulating layers 10, 20, 30, 40, and 50 sequentially laminated on the buffer layer BFL may be inorganic layers, and sixth and seventh insulating layers 60 and 70 may be organic layers.

The first insulating layer 10 may be disposed on the buffer layer BFL and the first semiconductor pattern ACT1. The first insulating layer 10 may cover the first semiconductor pattern ACT1. The first insulating layer 10 may be an inorganic layer and/or an organic layer and may have a single-layer structure or a multi-layer structure. The first insulating layer 10 may include at least one of aluminum oxide, titanium oxide, silicon oxide, silicon nitride, silicon oxy nitride, zirconium oxide, and/or hafnium oxide. In one or more embodiments, the first insulating layer 10 may be a single-layer silicon oxide layer. An insulating layer of the circuit layer 312, which will be described, as well as the first insulating layer 10 may have a single-layer structure or a multi-layer structure.

Gate electrodes (hereinafter, referred to as a first gate electrode GE1) of the first type or kind transistors TFT1a and TFT1b may be arranged on the first insulating layer 10. The first gate electrode GE1 may be a portion of a metal pattern. The first gate electrode GE1 overlaps the active area AC1 in the third direction DR3. In a process of doping the first semiconductor pattern ACT1, the first gate electrode GE1 may function as a mask. The first gate electrode GE1 may include titanium, silver, an alloy containing silver, molybdenum, an alloy containing molybdenum, aluminum, an alloy containing aluminum, aluminum nitride, tungsten, tungsten nitride, copper, indium tin oxide, and/or indium zinc oxide, but the present invention is not particularly limited thereto.

In one or more embodiments, the first semiconductor pattern ACT1 and the first gate electrode GE1 of the first type or kind transistor TFT1b in the second area A2 may be arranged to overlap the lower light shielding pattern BLBP on a plane. Therefore, the light beam (e.g., the infrared light beam) emitted from the electronic module 400 (see FIG. 2A), which is introduced to a lower side of the second pixel circuit PC-2, may be prevented, reduced, or restrained from reaching the first type or kind transistor TFT1b.

The second insulating layer 20 may be disposed on the first insulating layer 10 to cover the first gate electrode GE1. The second insulating layer 20 may be an inorganic layer and may have a single-layer structure or a multi-layer structure. The second insulating layer 20 may include at least one of silicon oxide, silicon nitride, and/or silicon oxy nitride. In one or more embodiments, the second insulating layer 20 may have a single-layer structure including a silicon nitride layer.

An upper electrode UE may be disposed on the second insulating layer 20. The upper electrode UE may overlap the first gate electrode GE1 in the third direction DR3 (e.g., in a plan view). The upper electrode UE may be a portion of the metal pattern or may be a portion of the doped semiconductor pattern. A portion of the first gate electrode GE1 and the upper electrode UE overlapping the portion of the first gate electrode GE1 may define the capacitor Cst (see FIG. 3B).

The third insulating layer 30 may be disposed on the second insulating layer 20 to cover the upper electrode UE. The third insulating layer 30 may be an inorganic layer and may have a single-layer structure or a multi-layer structure. For example, the third insulating layer 30 may have a multi-layer structure including a silicon oxide layer and a silicon nitride layer.

Semiconductor patterns (hereinafter, referred to as a second semiconductor pattern ACT2) of the second type or kind transistors TFT2a and TFT2b may be arranged on the third insulating layer 30. The second semiconductor pattern ACT2 may include an oxide semiconductor. The oxide semiconductor may include a plurality of areas classified according to whether a metal oxide is reduced. An area (hereinafter, referred to as a reduced area), in which the metal oxide is reduced, has higher conductivity than that of an area (hereinafter, referred to as a non-reduced area), in which the metal oxide is not reduced. The reduced area substantially serves as source areas/drain areas or signal lines of the second type or kind transistors TFT2a and TFT2b. The non-reduced area substantially corresponds to active areas (or semiconductor areas or channels) of the second type or kind transistors TFT2a and TFT2b. In other words, a portion of the second semiconductor pattern ACT2 may be active areas of the second type or kind transistors TFT2a and TFT2b, another portion thereof may be source areas/drain areas of the second type or kind transistors TFT2a and TFT2b, and still another portion thereof may be signal transmitting areas.

A source area S2, an active area AC2, and a drain area D2 of the second type or kind transistors TFT2a and TFT2b may be formed from the second semiconductor pattern ACT2. The source area S2 and the drain area D2 may extend from the active area AC2 in opposite directions in a cross section.

The fourth insulating layer 40 may be disposed on the third insulating layer 30. The fourth insulating layer 40 may cover the second semiconductor pattern ACT2. The fourth insulating layer 40 may be an inorganic layer and may have a single-layer structure or a multi-layer structure. The fourth insulating layer 40 may include at least one of aluminum oxide, titanium oxide, silicon oxide, silicon nitride, silicon oxy nitride, zirconium oxide, and/or hafnium oxide. In one or more embodiments, the fourth insulating layer 40 may have a single-layer structure containing silicon oxide.

Gate electrodes (hereinafter, referred to as a second gate electrode GE2) of the second type or kind transistors TFT2a and TFT2b may be arranged on the fourth insulating layer 40. The second gate electrode GE2 may be a portion of a metal pattern. The second gate electrode GE2 overlaps the active area AC2 in the third direction DR3. In a process of doping the second semiconductor pattern ACT2, the second gate electrode GE2 may function as a mask.

In one or more embodiments, the second semiconductor pattern ACT2 and the second gate electrode GE2 of the second type or kind transistor TFT2b in the second area A2 may be arranged to overlap the lower light shielding pattern BLBP on a plane. Therefore, the light beam (e.g., the infrared light beam) emitted from the electronic module 400 (see FIG. 2A), which is introduced to the lower side of the second pixel circuit PC-2, may be prevented, reduced, or restrained from reaching the second type or kind transistor TFT2b.

In one or more embodiments, the second type or kind transistor TFT2b may be referred to as an additional transistor, the second semiconductor pattern ACT2 may be referred to as an additional semiconductor pattern, and the second gate electrode GE2 may be referred to as an additional gate electrode.

The fifth insulating layer 50 may be disposed on the fourth insulating layer 40 to cover the second gate electrode GE2. The fifth insulating layer 50 may be an inorganic layer and/or an organic layer and may have a single-layer structure or a multi-layer structure. For example, the fifth insulating layer 50 may have a multi-layer structure including a silicon oxide layer and a silicon nitride layer.

A first connection electrode CNE1 and a second connection electrode CNE2 may be arranged on the fifth insulating layer 50. The first connection electrode CNE1 may be connected to the connection signal line SCL through a contact hole CH1 passing through the first to fifth insulating layers 10, 20, 30, 40, and 50. The second connection electrode CNE2 may be connected to the second semiconductor pattern ACT2 through a contact hole CH2 passing through the fourth and fifth insulating layers 40 and 50.

The sixth insulating layer 60 may be disposed on the fifth insulating layer 50 to cover the first and the second connection electrodes CNE1 and CNE2. The sixth insulating layer 60 may be an organic material.

A third connection electrode CNE3 (or an upper connection electrode) may be disposed on the sixth insulating layer 60. The third connection electrode CNE3 may be connected to the first connection electrode CNE1 through a contact hole CH3 passing through the sixth insulating layer 60.

The seventh insulating layer 70 may be disposed on the sixth insulating layer 60 to cover the third connecting electrode CNE3. The seventh insulating layer 70 may be an organic material. For example, each of the sixth insulating layer 60 and the seventh insulating layer 70 may include general purpose polymers such as benzocyclobutene (BCB), polyimide, hexamethyldisiloxane (HMDSO), polymethylmethacrylate (PMMA), and polystyrene (PS), a polymer derivative having a phenolic group, an acryl-based polymer, an imide-based polymer, an arylether-based polymer, an amide-based polymer, a fluorine-based polymer, a p-xylene-based polymer, a vinyl alcohol-based polymer, and /or blends thereof.

The light emitting element layer 313 including the first and second light emitting elements LD-1 and LD-2 may be disposed on the circuit layer 312. Each of the first and second light emitting elements LD-1 and LD-2 may include a pixel electrode AE (or an anode), also termed as first electrode herein, a first functional layer HFL, a light emitting layer EL, a second functional layer EFL, and a common electrode CE (or a cathode), also termed as a second electrode herein. The first functional layer HFL, the second functional layer EFL, and the common electrode CE may be commonly provided to the pixels PX (see FIG. 2A).

The pixel electrode AE may be disposed on the seventh insulating layer 70. The pixel electrode AE may be connected to the third connection electrode CNE3 through a contact hole CH4 passing through the seventh insulating layer 70. The pixel electrode AE may be a transmissive (semi-transmissive) electrode or a reflective electrode. In one or more embodiments, the pixel electrode AE may include a reflective layer formed of silver, magnesium, aluminum, platinum, palladium, gold, nickel, neodymium, iridium, chromium, and/or a compound thereof and/or a transparent or semitransparent electrode layer formed on the reflective layer. The transparent or semitransparent electrode layer may include at least one selected from the group consisting of indium tin oxide, indium zinc oxide, indium gallium zinc oxide, zinc oxide or indium oxide, and aluminum-doped zinc oxide. For example, the pixel electrode AE may include a multi-layer structure in which indium tin oxide, silver, and/or indium tin oxide are sequentially laminated.

A pixel defining film PDL may be disposed on the seventh insulating layer 70. Light emitting openings P1-OP and P2-OP exposing portions of the pixel electrodes AE may be defined in the pixel defining film PDL. The pixel defining film PDL may cover an edge of the pixel electrode AE. Light emitting areas PXA1 and PXA2 may be defined by the light emitting openings P1-OP and P2-OP defined in the pixel defining film PDL. For example, the first light emitting area PXA1 may be defined with respect to the first light emitting element LD-1, and the second light emitting area PXA2 may be defined with respect to the second light emitting element LD-2.

The pixel defining film PDL may have a property of absorbing a light beam, and, for example, the pixel defining film PDL may have a black color. The pixel defining film PDL may include a black coloring agent. The black coloring agent may include black dye and/or black pigment. The black coloring agent may include carbon black, metal such as chromium, and/or an oxide thereof.

The first functional layer HFL may be disposed on the pixel electrode AE and the pixel defining film PDL. The first functional layer HFL may include a hole transport layer, a hole injection layer, or the both (e.g., simultaneously) the hole transport layer and the hole injection layer. The first functional layer HFL may be disposed in the entirety of the first area A1 and the second area A2.

The light emitting layer EL may be disposed on the first functional layer HFL and may be disposed in an area corresponding to the light emitting openings P1-OP and P2-OP of the pixel defining film PDL. The light emitting layer EL may include an organic material, an inorganic material, and/or an organic/inorganic material configured to emit a light beam having a suitable color (e.g., a set or predetermined color). The light emitting layer EL may be disposed in the first area A1 and the second area A2. The light emitting layer EL disposed in the second area A2 may be disposed in an area spaced from the transmissive area TA, that is, in the element area EA.

The second functional layer EFL may be disposed on the light emitting layer EL and cover the light emitting layer EL. The second functional layer EFL may include an electron transport layer, an electron injection layer, or the both (e.g., simultaneously) the electron transport layer and the electron injection layer. The second functional layer EFL may be disposed in the entirety of the first area A1 and the second area A2.

The common electrode CE may be disposed on the second functional layer EFL. The common electrode CE may be commonly disposed in the plurality of pixels PX (see FIG. 2A).

The encapsulation layer 314 may be disposed on the light emitting element layer 313. The encapsulation layer 314 may include an inorganic layer 81, an organic layer 82, and an inorganic layer 83 sequentially laminated, and layers constituting the encapsulation layer 314 are not limited thereto.

The inorganic layers 81 and 83 may protect the light emitting element layer 313 from moisture and oxygen, and the organic layer 82 may protect the light emitting element layer 313 from foreign substances such as dust particles. The inorganic layers 81 and 83 may include a silicon nitride layer, a silicon oxy nitride layer, a silicon oxide layer, a titanium oxide layer, an aluminum oxide layer, and/or the like. The organic layer 82 may include an acryl-based organic layer, but the present invention is not limited thereto.

The transmissive area TA of the second area A2 may be defined as an area, in which conductive materials or insulating layers are patterned or not deposited to improve light transmittance.

In one or more embodiments, from among the first to seventh insulating layers 10, 20, 30, 40, 50, 60, and 70, the first insulating layer 10, the second insulating layer 20, the third insulating layer 30, the fourth insulating layer 40, the fifth insulating layer 50, and the seventh insulating layer 70 may be provided so as not to be deposited in the transmissive area TA or to be patterned and removed after deposition. Accordingly, the first to fifth insulating layers 10, 20, 30, 40, and 50 and the seventh insulating layer 70 arranged inside the second area A2 may not overlap the transmissive area TA.

The lower light shielding pattern BLBP may not overlap at least a portion of the transmissive area TA. FIG. 5B illustrates a cross section of a portion of the lower light shielding pattern BLBP, in which an opening B-OP overlapping the transmissive area TA is defined, but in one or more embodiments of the present invention, the portion of the lower light shielding pattern BLBP may extend across the transmissive area TA. In this case, the lower light shielding pattern BLBP may have an entirely integral pattern within the second area A2.

A side surface of the lower light shielding pattern BLBP, which defines the opening B-OP, may be covered by the buffer layer BFL that is not patterned. The barrier layer BRL exposed by the opening B-OP of the lower light shielding pattern BLBP may also be covered by the buffer layer BFL.

Further, in the first to fifth insulating layers 10, 20, 30, 40, and 50, a transmissive opening IL-OP may be defined by side surfaces formed through patterning, and the side surfaces defining the transmissive opening IL-OP may be covered by the sixth insulating layer 60 that is not patterned from among the organic insulating layers.

Further, the common electrode CE from among components of the second light emitting element LD-2 may also be provided so as not to be deposited in the transmissive area TA or to be patterned and removed after deposition. In one or more embodiments, when an opening CE-OP of the common electrode CE is formed, the lower light shielding pattern BLBP may function as a mask. For example, a light beam irradiated toward the common electrode CE from a rear surface of the base layer 311 may pass through the opening B-OP of the lower light shielding pattern BLBP and reach a portion of the common electrode CE. For example, the portion of the common electrode CE may be removed by the light beam passing through the opening B-OP of the lower light shielding pattern BLBP. The light beam may be a laser beam. In this case, the lower light shielding pattern BLBP may prevent or protect components arranged on the lower light shielding pattern BLBP from being damaged by the laser beam.

According to one or more embodiments, the first functional layer HFL and the second functional layer EFL may not be patterned and may be disposed to overlap the transmissive area TA. In this case, a side surface defining the opening CE-OP of the common electrode CE may be covered by the second functional layer EFL.

In one or more embodiments, a base layer part 311-P, a barrier layer part BRL-P, a buffer layer part BFL-P, a sixth insulating layer part 60-P, a first functional part HFL-P, a second functional part EFL-P, a first inorganic part 81-P, an organic part 82-P, and a second inorganic part 83-P may be arranged in the transmissive area TA.

To compensate for a step difference between the insulating layers that are not deposited in the transmissive area TA or are patterned after deposition, areas of the organic layer 82 of the encapsulation layer 314 may have different thicknesses. For example, a thickness of the organic layer82 overlapping the transmissive area TA in the organic layer 82 may be greater than a maximum thickness of the organic layer82 overlapping the first area A1 and the element area EA in the organic layer 82.

According to one or more embodiments of the present invention, the second area A2 may be an area having higher light transmittance than that of the first area A1, and the transmissive area TA in the second area A2 may have highest light transmittance.

In one or more embodiments, the side light shielding pattern SLBP may be disposed in the second area A2. The side light shielding pattern SLBP may be disposed on the fifth insulating layer 50 and covered by the sixth insulating layer 60. The side light shielding pattern SLBP may be disposed on (e.g., at) the same layer as that of the first connection electrode CNE1. In one or more embodiments, the side light shielding pattern SLBP may include the same material as that of the first connection electrode CNE1. The side light shielding pattern SLBP may be formed concurrently (e.g., simultaneously) in a process of forming the first connection electrode CNE1.

The side light shielding pattern SLBP may be connected to the lower light shielding pattern BLBP through a contact hole passing through the insulating layers arranged between the first semiconductor pattern ACT1 and the first connection electrode CNE1 and the buffer layer BFL. In one or more embodiments, the side light shielding pattern SLBP may be in contact with the lower light shielding pattern BLBP through a contact hole CH5 passing through the buffer layer BFL and the first to fifth insulating layers 10, 20, 30, 40, and 50.

The side light shielding pattern SLBP may include the first side pattern SLBP1 and the second side pattern SLBP2. The first side pattern SLBP1 and the second side pattern SLBP2 may be spaced from (or face) each other with the second pixel circuit PC-2 interposed therebetween.

The first side pattern SLBP1 and the second side pattern SLBP2 may include first parts P1-1 and P1-2 and second parts P2-1 and P2-2. The first parts P1-1 and P1-2 may be parts arranged on the fifth insulating layer 50, and the second parts P2-1 and P2-2 may be parts that pass through the first to fifth insulating layers 10, 20, 30, 40, and 50 and extend in a thickness direction (i.e., the third direction DR3). The first parts P1-1 and P1-2 may extend in one direction, and the second parts P2-1 and P2-2 may also extend in the one direction along the first parts P1-1 and P1-2. A detail description thereof will be made.

In one or more embodiments, side portions of the first semiconductor pattern ACT1 and the first gate electrode GE1 of the first type or kind transistor TFT1b in the second area A2 may be covered through the side light shielding pattern SLBP. Further, side portions of the second semiconductor pattern ACT2 and the second gate electrode GE2 of the second type or kind transistor TFT2b in the second area A2 may be covered through the side light shielding pattern SLBP. Therefore, the light beam (e.g., the infrared light beam) emitted from the electronic module 400 (see FIG. 2A), which is introduced to a lateral side of the second pixel circuit PC-2, may be prevented, reduced, or restrained from reaching the first and second type or kind transistors TFT1b and TFT2b.

Further, the light beam (e.g., the infrared light beam) emitted from the electronic module 400 (see FIG. 2A) may be transmitted along the buffer layer BFL including an inorganic layer and the first to fifth insulating layers 10, 20, 30, 40, and 50. However, according to one or more embodiments, the light beam may be prevented, reduced, or restrained from being transmitted to a portion, in which the second pixel circuit PC-2 is disposed, through the side light shielding pattern SLBP.

In one or more embodiments, an upper light shielding pattern ULBP may be disposed in the second area A2. The upper light shielding pattern ULBP may be disposed on the seventh insulating layer 70 and covered by the pixel defining film PDL. The upper light shielding pattern ULBP may be disposed on (e.g., at) the same layer as that of the pixel electrode AE. In one or more embodiments, the upper light shielding pattern ULBP may include the same material as that of the pixel electrode AE. The upper light shielding pattern ULBP may be formed concurrently (e.g., simultaneously) in a process of forming the pixel electrode AE.

An opening U-OP may be defined in the upper light shielding pattern ULBP. The pixel electrode AE may be disposed inside the opening U-OP of the upper light shielding pattern ULBP. For example, the pixel electrode AE may be at least partially surrounded by the upper light shielding pattern ULBP.

As illustrated in FIG. 5B, an upper portion of the second type or kind transistor TFT2b (e.g., the second semiconductor pattern ACT2 and the second gate electrode GE2) in the second area A2 may be at least partially covered through the upper light shielding pattern ULBP. Further, FIG. 5B illustrates, as an example, the first type or kind transistor TFT1b disposed to overlap the pixel electrode AE (e.g., in the third direction DR3 or in the plan view), but the other portion of the first type or kind transistor TFT1b may not overlap the pixel electrode AE. An upper portion of the first type or kind transistor TFT1b (e.g., the first semiconductor pattern ACT1 and the first gate electrode GE1) not overlapping the pixel electrode AE may also be at least partially covered through the upper light shielding pattern ULBP.

The light beam (e.g., the infrared light beam) emitted from the electronic module 400 (see FIG. 2A) may be reflected by the common electrode CE and introduced to an upper side of the second pixel circuit PC-2. However, according to one or more embodiments, the light beam reflected by the common electrode CE, which is introduced to the upper side of the second pixel circuit PC-2, may be prevented, reduced, or restrained from reaching the first and second type or kind transistors TFT1b and TFT2b due to the upper light shielding pattern ULBP.

Thus, according to one or more embodiments of the present invention, the electronic module 400 (see FIG. 2A) may be disposed to overlap an inside of the display area DA (see FIG. 1), and even when the transmissive area TA is disposed adjacent to the element area EA, the light beam (e.g., the infrared light beam) emitted from the electronic module 400 (see FIG. 2A) may be prevented, reduced, or restrained from being introduced into the lower side, the lateral side, and the upper side of the second pixel circuit PC-2. Therefore, damage to the transistors due to the infrared light beam may be prevented or reduced, and changes in characteristics of the transistors may be prevented or reduced. Therefore, a leakage current (e.g., an off-leakage current flowing in a state in which the transistor is turned off) occurs in the transistor may be prevented, and thus occurrence of abnormal light emission in the light emitting element may be prevented, reduced, or restrained. Thus, the electronic device 1000 (see FIG. 1) having improved display quality may be provided.

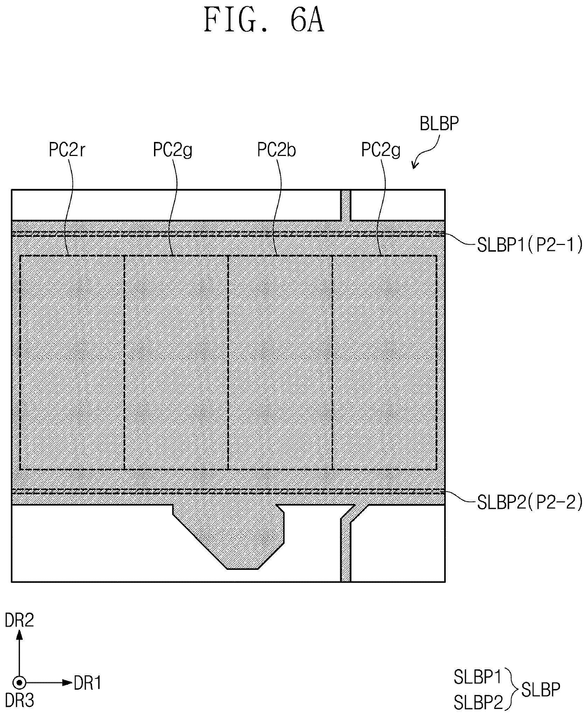

FIG. 6A is a plan view illustrating a portion of the lower light shielding pattern according to one or more embodiments of the present invention. FIG. 6A illustrates a portion of the lower light shielding pattern BLBP disposed in the second area A2 (see FIG. 5B).

Referring to FIGS. 5B and 6A, the lower light shielding pattern BLBP may be disposed between the barrier layer BRL and the buffer layer BFL. In FIG. 6A, the (1-2)^{th} to (3-2)^{th} pixel circuits PC2r, PC2g, and PC2b included in the one second pixel group PXU2 (see FIG. 4B) are illustrated by dotted lines. All the (1-2)^{th} to (3-2)^{th} pixel circuits PC2r, PC2g, and PC2b may be arranged to overlap the lower light shielding pattern BLBP on a plane.

For convenience of description, FIG. 6A illustrates a portion of the lower light shielding pattern BLBP, which is in contact with the side light shielding pattern SLBP together. The side light shielding pattern SLBP may include the first side pattern SLBP1 and the second side pattern SLBP2. The second parts P2-1 and P2-2 of the first and second side patterns SLBP1 and SLBP2 may be in contact with the lower light shielding pattern BLBP. The second parts P2-1 and P2-2 of the first and second side patterns SLBP1 and SLBP2 may extend in the first direction DR1.

On a plane (e.g., in the second direction DR2 in a plan view), the second part P2-1 of the first side pattern SLBP1 may be disposed on upper sides of the (1-2)^{th} to (3-2)^{th} pixel circuits PC2r, PC2g, and PC2b and may be in contact with the lower light shielding pattern BLBP on the upper sides of the (1-2)^{th} to (3-2)^{th} pixel circuits PC2r, PC2g, and PC2b. On a plane (e.g., in a plan view), the second part P2-2 of the second side pattern SLBP2 may be disposed on lower sides of the (1-2)^{th} to (3-2)^{th} pixel circuits PC2r, PC2g, and PC2b and may be in contact with the lower light shielding pattern BLBP on the lower sides of the (1-2)^{th} to (3-2)^{th} pixel circuits PC2r, PC2g, and PC2b. The light beam (e.g., the infrared light beam) may be prevented or reduced from being introduced into the (2-1)^{th} to (3-2)^{th} pixel circuits PC2r, PC2g, and PC2b from the transmissive area TA (see FIG. 4B) adjacent to the element area EA (see FIG. 4B), through the first and second side patterns SLBP1 and SLBP2.

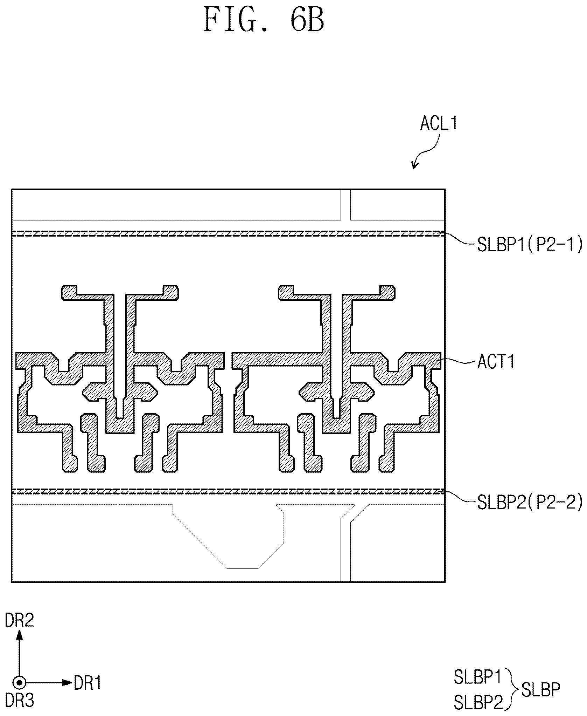

FIGS. 6B to 6H are plan views illustrating one layer constituting pixel circuits arranged in the second area according to one or more embodiments of the present invention. FIGS. 6B to 6H are plan views illustrating an arrangement order of conductive patterns and semiconductor patterns included in the circuit layer 312 (see FIG. 5B) of the second area A2 (see FIG. 5B). The same/similar reference numerals are utilized for the same/similar components described in FIGS. 1 to 5B, and a duplicated description thereof will not be provided.

FIGS. 6B to 6H illustrate components included in the (1-2)^{th} pixel circuit PC2r (see FIG. 6A), the (2-2)^{th} pixel circuit PC2g (see FIG. 6A), the (3-2)^{th} pixel circuit PC2b (see FIG. 6A), and the (2-2)^{th} pixel circuit PC2g (see FIG. 6A), which are arranged inside the one second pixel group PXU2 (see FIG. 4B) along the second direction DR2. For convenience of description, FIGS. 6B to 6G each illustrate a portion of the side light shielding pattern SLBP, which passes through the insulating layers of the circuit layer 312 (see FIG. 5B). The second parts P2-1 and P2-2 of the side light shielding pattern SLBP may pass through the insulating layers of the circuit layer 312 (see FIG. 5B).

Referring to FIGS. 5B and 6B, a first semiconductor layer ACL1 may be disposed between the buffer layer BFL and the first insulating layer 10. The first semiconductor layer ACL1 may include a silicon semiconductor. For example, the silicon semiconductor may include amorphous silicon, polycrystalline silicon, and/or the like. For example, the first semiconductor layer ACL1 may include low-temperature polysilicon. The first semiconductor layer ACL1 may include the first semiconductor patterns ACT1 included in the (1-2)^{th} to (3-2)^{th} pixel circuits PC2r, PC2g, and PC2b (see FIG. 6A).

On a plane (e.g., in a plan view), all the first semiconductor patterns ACT1 may overlap the lower light shielding pattern BLBP. Therefore, the light beam (e.g., the infrared light beam) emitted from the electronic module 400 (see FIG. 2A), which is introduced to the lower side of the second pixel circuit PC-2 (see FIG. 5B), may be prevented, reduced, or restrained from reaching the first semiconductor patterns ACT1.

The side light shielding pattern SLBP illustrated in FIG. 6B may be a portion passing through the first insulating layer 10. All the first semiconductor patterns ACT1 may overlap the side light shielding pattern SLBP in a cross section viewed in a direction perpendicular to an extension direction of the side light shielding pattern SLBP.

In more detail, when viewed in the second direction DR2, all the first semiconductor patterns ACT1 may overlap the first side pattern SLBP1 (e.g., the second part P2-1). When viewed in an opposite direction to the second direction DR2, all the first semiconductor patterns ACT1 may overlap the second side pattern SLBP2 (e.g., the second part P2-2).

Therefore, the light beam (e.g., the infrared light beam) emitted from the electronic module 400 (see FIG. 2A), which is introduced to the lateral side of the second pixel circuit PC-2 (see FIG. 5B), may be prevented, reduced, or restrained from reaching the first semiconductor patterns ACT1.

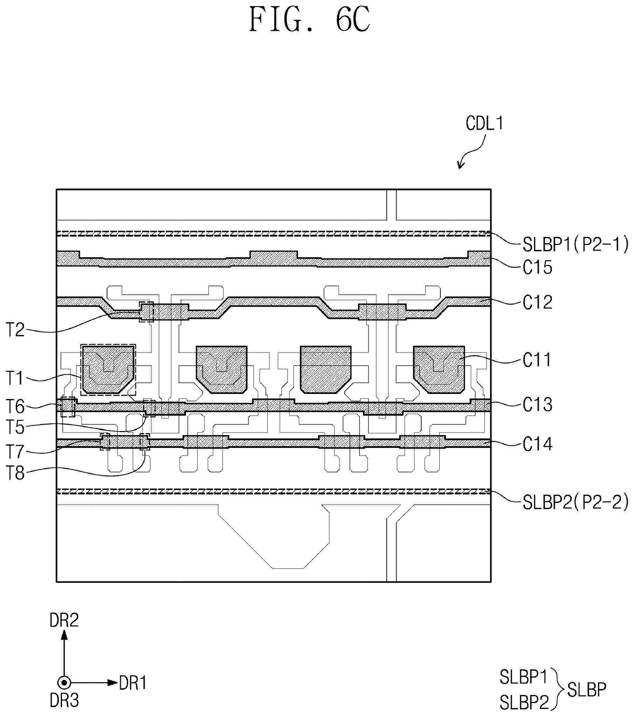

Referring to FIGS. 5B and 6C, a first conductive layer CDL1 may be disposed between the first insulating layer 10 and the second insulating layer 20. The first conductive layer CDL1 may include a metal, an alloy, a conductive metal oxide, a transparent conductive material, and/or the like. For example, the first conductive layer CDL1 may include silver, an alloy containing silver, molybdenum, an alloy containing molybdenum, aluminum, an alloy containing aluminum, aluminum nitride, tungsten, tungsten nitride, copper, indium tin oxide, indium zinc oxide, and/or the like, but the present invention is not particularly limited thereto.

The first conductive layer CDL1 may include first to fifth conductive patterns C11, C12, C13, C14, and C15.

The first conductive pattern C11 may be the first gate electrode GE1 illustrated in FIG. 5B. The first conductive pattern C11 may be disposed in an island shape. The first conductive pattern C11 together with the first semiconductor pattern ACT1 (see FIG. 6B) may constitute the first transistor T1.

The second conductive pattern C12 may correspond to the j^{th} writing scan line GWLj of FIG. 3B. The second conductive pattern C12 together with the first semiconductor pattern ACT1 (see FIG. 6B) may constitute the second transistor T2.

The third conductive pattern C13 may correspond to the j^{th} light emitting control line ECLj of FIG. 3B. The third conductive pattern C13 together with the first semiconductor pattern ACT1 (see FIG. 6B) may constitute the fifth transistor T5 and the sixth transistor T6.

The fourth conductive pattern C14 may correspond to the j^{th} black scan line GBLj of FIG. 3B. The fourth conductive pattern C14 together with the first semiconductor pattern ACT1 (see FIG. 6B) may constitute the seventh transistor T7 and the eighth transistor T8.

The fifth conductive pattern C15 may be a portion of the first initialization voltage line VL3 (see FIG. 3B) to which the first initialization voltage VINT (see FIG. 3B) is provided.

The side light shielding pattern SLBP illustrated in FIG. 6C may be a portion passing through the second insulating layer 20. All the first, second, and fifth to eighth transistors T1, T2, T5, T6, T7, and T8 may overlap the side light shielding pattern SLBP in a cross section viewed in the direction perpendicular or normal to the extension direction of the side light shielding pattern SLBP. In more detail, when viewed in the second direction DR2, each of the first, second, and fifth to eighth transistors T1, T2, T5, T6, T7, and T8 may overlap the first side pattern SLBP1 (e.g., the second part P2-1). When viewed in the opposite direction to the second direction DR2, each of the first, second, and fifth to eighth transistors T1, T2, T5, T6, T7, and T8 may overlap the second side pattern SLBP2 (e.g., the second part P2-2).

Therefore, the light beam (e.g., the infrared light beam) emitted from the electronic module 400 (see FIG. 2A), which is introduced to the lateral side of the second pixel circuit PC-2 (see FIG, 5B), may be prevented, reduced, or restrained from reaching the first, second, and fifth to eighth transistors T1, T2, T5, T6, T7, and T8. Thus, changes in characteristics of the first, second, and fifth to eighth transistors T1, T2, T5, T6, T7, and T8 may be prevented or reduced.

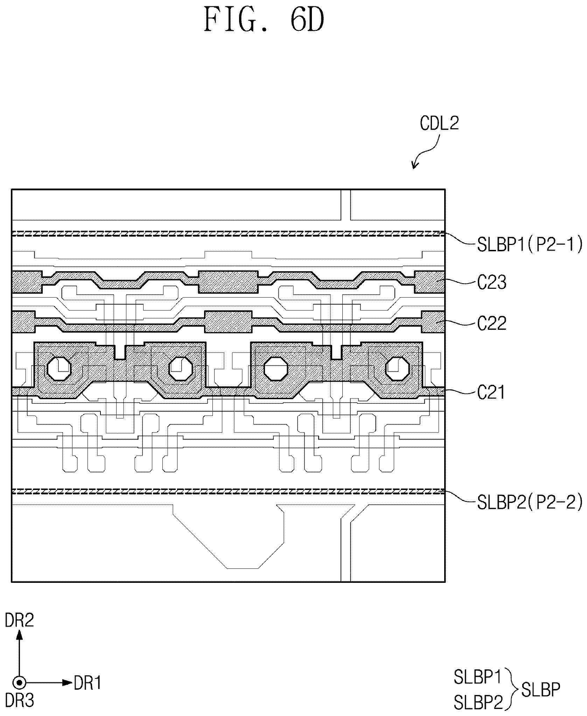

Referring to FIGS. 5B and 6D, a second conductive layer CDL2 may be disposed between the second insulating layer 20 and the third insulating layer 30. The second conductive layer CDL2 may include a metal, an alloy, a conductive metal oxide, a transparent conductive material, and/or the like. For example, the second conductive layer CDL2 may have a single-layer structure containing molybdenum.

The second conductive layer CDL2 may include first to third conductive patterns C21, C22, and C23.

The first conductive pattern C21 may overlap the first conductive pattern C11 (see FIG. 6C) of the first conductive layer CDL1 (see FIG. 6C). The first conductive pattern C21 together with the first conductive pattern C11 (see FIG. 6C) may constitute the capacitor Cst (see FIG. 3B). The first driving voltage ELVDD (see FIG. 3B) may be provided to the first conductive pattern C21.

The second conductive pattern C22 may correspond to the j^{th} compensation scan line GCLj of FIG. 3B. The third conductive pattern C23 may correspond to the j^{th} initialization scan line GILj of FIG. 3B.

The side light shielding pattern SLBP illustrated in FIG. 6D may be a portion passing through the third insulating layer 30.

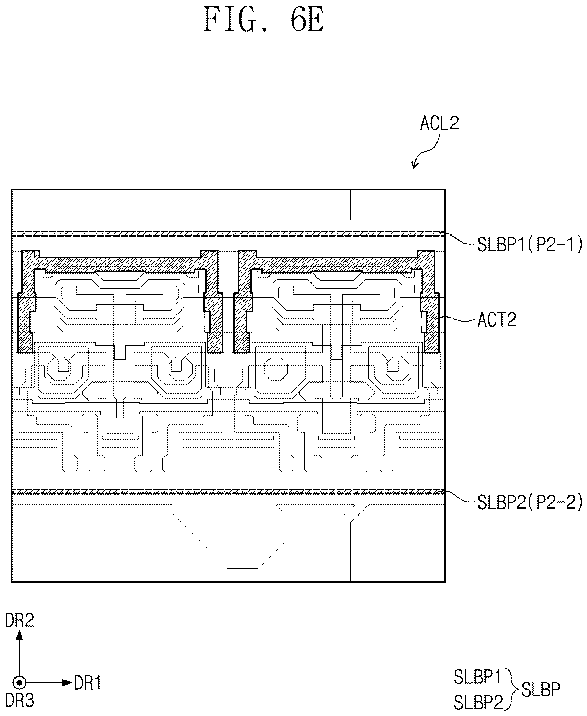

Referring to FIGS. 5B and 6E, a second semiconductor layer ACL2 may be disposed between the third insulating layer 30 and the fourth insulating layer 40. The second semiconductor layer ACL2 may include an oxide semiconductor. The second semiconductor layer ACL2 may include the second semiconductor patterns ACT2 included in the (1-2)^{th} to (3-2)^{th} pixel circuits PC2r, PC2g, and PC2b. The second semiconductor patterns ACT2 may be arranged on a different layer from that of the first semiconductor patterns ACT1, and the second semiconductor patterns ACT2 may not overlap the first semiconductor patterns ACT1.

On a plane, all the second semiconductor patterns ACT2 may overlap the lower light shielding pattern BLBP (e.g., in a third direction DR3 or in a plan view). Therefore, the light beam (e.g., the infrared light beam) emitted from the electronic module 400 (see FIG. 2A), which is introduced to the lower side of the second pixel circuit PC-2 (see FIG. 5B), may be prevented, reduced, or restrained from reaching the second semiconductor patterns ACT2.

The side light shielding pattern SLBP illustrated in FIG. 6E may be a portion passing through the fourth insulating layer 40. All the second semiconductor patterns ACT2 may overlap the side light shielding pattern SLBP in a cross section viewed in the direction perpendicular to the extension direction of the side light shielding pattern SLBP.

In more detail, when viewed in the second direction DR2, all the second semiconductor patterns ACT2 may overlap the first side pattern SLBP1 (e.g., the second part P2-1). When viewed in the opposite direction to the second direction DR2, all the second semiconductor patterns ACT2 may overlap the second side pattern SLBP2 (e.g., the second part P2-2).

Therefore, the light beam (e.g., the infrared light beam) emitted from the electronic module 400 (see FIG. 2A), which is introduced to the lateral side of the second pixel circuit PC-2 (see FIG. 5B), may be prevented, reduced, or restrained from reaching the second semiconductor patterns ACT2.

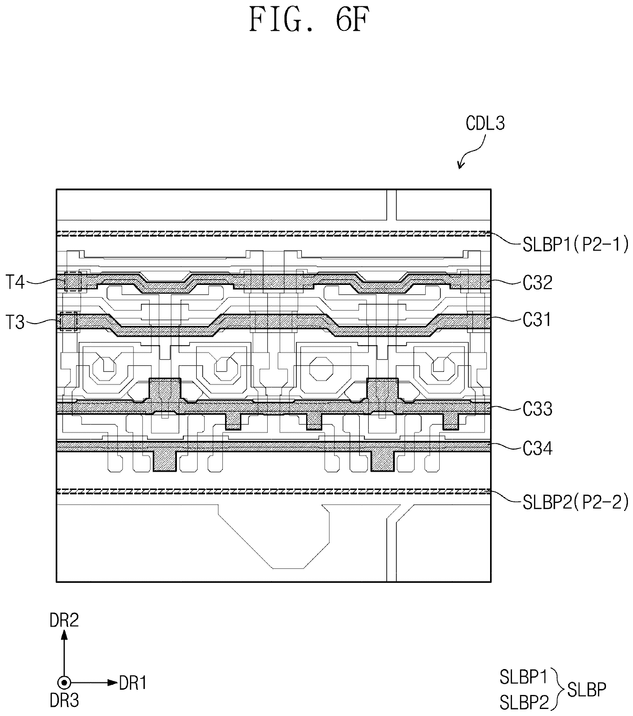

Referring to FIGS. 5B and 6F, a third conductive layer CDL3 may be disposed between the fourth insulating layer 40 and the fifth insulating layer 50. The third conductive layer CDL3 may include a metal, an alloy, a conductive metal oxide, a transparent conductive material, and/or the like. The third conductive layer CDL3 may have a multi-layer structure in which titanium and molybdenum are sequentially laminated, but the present invention is not particularly limited thereto.

The third conductive layer CDL3 may include first to fourth conductive patterns C31, C32, C33, and C34.

The first conductive pattern C31 may correspond to the j^{th} compensation scan line GCLj of FIG. 3B. The first conductive pattern C31 together with the second semiconductor pattern ACT2 (see FIG. 6E) may constitute the third transistor T3.

The second conductive pattern C32 may correspond to the j^{th} initialization scan line GILj of FIG. 3B. The second conductive pattern C32 together with the second semiconductor pattern ACT2 (see FIG. 6E) may constitute the fourth transistor T4.

The third conductive pattern C33 may be a portion of the second initialization voltage line VL4 (see FIG. 3B) to which the second initialization voltage VAINT (see FIG. 3B) is provided. According to one or more embodiments, the third conductive pattern C33 may be electrically connected to the (2-2)^{th} and (3-2)^{th} pixel circuits PC2g and PC2b (see FIG. 6A) and provide the second initialization voltage VAINT (see FIG. 3B) to the (2-2)^{th} and (3-2)^{th} pixel circuits PC2g and PC2b (see FIG. 6A).

The fourth conductive pattern C34 may be a portion of the bias voltage line VL5 (see FIG. 3B) to which the bias voltage VOBS (see FIG 3B) is provided.

The side light shielding pattern SLBP illustrated in FIG. 6F may be a portion passing through the fifth insulating layer 50. Both the third and fourth transistors T3 and T4 may overlap the side light shielding pattern SLBP in a cross section viewed in the direction perpendicular to the extension direction of the side light shielding pattern SLBP. When viewed in the second direction DR2, both (e.g., simultaneously) the third and fourth transistors T3 and T4 may overlap the first side pattern SLBP1 (e.g., the second part P2-1). When viewed in the opposite direction to the second direction DR2, both (e.g., simultaneously) the third and fourth transistors T3 and T4 may overlap the second side pattern SLBP2 (e.g., the second part P2-2).

Therefore, the light beam (e.g., the infrared light beam) emitted from the electronic module 400 (see FIG. 2A), which is introduced to the lateral side of the second pixel circuit PC-2 (see FIG. 5B), may be prevented, reduced, or restrained from reaching the third and fourth transistors T3 and T4. Thus, changes in characteristics of the third and fourth transistors T3 and T4 may be prevented, reduced, or reduced.

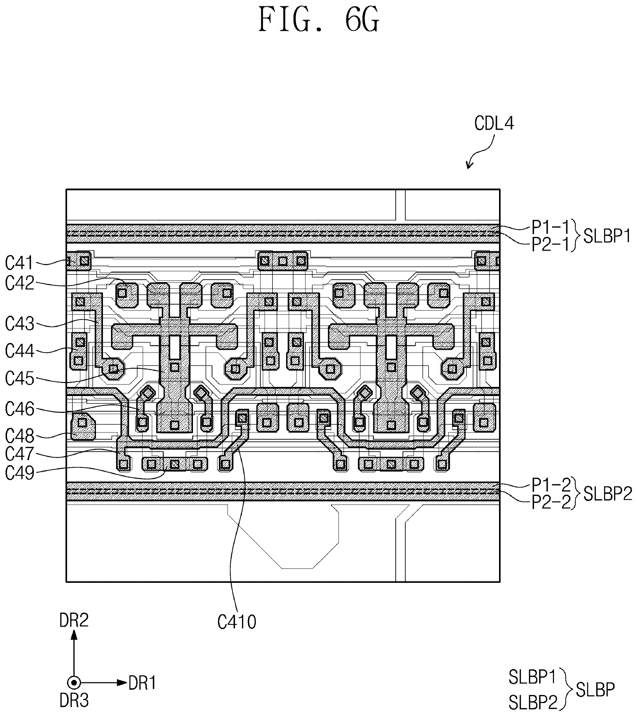

Referring to FIGS. 5B and 6G, a fourth conductive layer CDL4 may be disposed between the fifth insulating layer 50 and the sixth insulating layer 60. The fourth conductive layer CDL4 may include a metal, an alloy, a conductive metal oxide, a transparent conductive material, and/or the like. The fourth conductive layer CDL4 may have a multi-layer structure in which titanium, aluminum, and titanium are sequentially laminated, but the present invention is not particularly limited thereto.

The fourth conductive layer CDL4 may include first to tenth conductive patterns C41, C42, C43, C44, C45, C46, C47, C48, C49, and C410 and the first and second side patterns SLBP1 and SLBP2. The first to tenth conductive patterns C41, C42, C43, C44, C45, C46, C47, C48, C49, and C410 may be connection electrodes connected to one pattern or a plurality of patterns.

The first conductive pattern C41 may be connected to the fifth conductive pattern C15 (see FIG. 6C) of the first conductive layer CDL1 (see FIG. 6C) and the second semiconductor pattern ACT2 (see FIG. 6E). The second conductive pattern C42 may be connected to the first semiconductor pattern ACT1 (see FIG. 6B). The third conductive pattern C43 may be connected to the second semiconductor pattern ACT2 (see FIG. 6E) and the first conductive pattern C11 (see FIG. 6C) of the first conductive layer CDL1 (see FIG. 6C). In one or more embodiments, the first and third conductive patterns C41 and C43 may correspond to the second connection electrode CNE2 in FIG. 5B. The fourth conductive pattern C44 may be connected to the first semiconductor pattern ACT1 (see FIG. 6B) and the second semiconductor pattern ACT2 (see FIG. 6E).

The fifth conductive pattern C45 may be connected to the first semiconductor pattern ACT1 (see FIG. 6B) and the first conductive pattern C21 (see FIG. 6D) of the second conductive layer CDL2 (see FIG. 6D). The fifth conductive pattern C45 may be a portion of the first driving voltage line VL1 (see FIG. 3B) to which the first driving voltage ELVDD (see FIG. 3B) is provided. The first driving voltage ELVDD (see FIG. 3B) may be provided to the first conductive pattern C21 (see FIG. 6D) through the fifth conductive pattern C45. The sixth conductive pattern C46 may be connected to the first semiconductor pattern ACT1 (see FIG. 6B).

The seventh conductive pattern C47 may be connected to the first semiconductor pattern ACT1 (see FIG. 6B). The seventh conductive pattern C47 may be a portion of the second initialization voltage line VL4 (see FIG. 3B) to which the second initialization voltage VAINT (see FIG. 3B) is provided.

According to one or more embodiments, the seventh conductive pattern C47 may be electrically connected to the (2-2)^{th} pixel circuit PC2g and provide the second initialization voltage VAINT (see FIG. 3B) to the (2-2)^{th} pixel circuit PC2g. The first semiconductor pattern ACT1 (see FIG. 6B) to which the seventh conductive pattern C47 is connected may correspond to the first semiconductor pattern ACT1 (see FIG. 6B) in the (2-2)^{th} pixel circuit PC2g. The second initialization voltage VAINT (see FIG. 3B) provided to the (1-2)^{th} and (3-2)^{th} pixel circuits PC2r and PC2b and the second initialization voltage VAINT (see FIG. 3B) provided to the (2-2)^{th} pixel circuit PC2g may be different from each other.

FIGS. 6F and 6G illustrate, as an example, that the first initialization voltage line VL3 (see FIG. 3B) connected to the (1-2)^{th} and (3-2)^{th} pixel circuits PC2r and PC2b and the first initialization voltage line VL3 (see FIG. 3B) connected to the (2-2)^{th} pixel circuits PC2g are separated from each other to provide the first initialization voltages VINT (see FIG. 3B) having different levels, but the present invention is not limited thereto. For example, the (1-2)^{th} to (3-2)^{th} pixel circuits PC2r, PC2g, and PC2b may be connected to the same first initialization voltage line VL3 (see FIG. 3B), and the first initialization voltage VINT (see FIG. 3B) having the same level may be applied.

The eighth conductive pattern C48 may be connected to the first semiconductor pattern ACT1 (see FIG. 6B). In one or more embodiments, the eighth conductive pattern C48 may correspond to the first connection electrode CNE1 in FIG. 5B.

The ninth conductive pattern C49 may be connected to the first semiconductor pattern ACT1 (see FIG. 6B) and the fourth conductive pattern C34 (see FIG. 6F) of the third conductive layer CDL3 (see FIG. 6F). The ninth conductive pattern C49 may electrically connect the first semiconductor pattern ACT1 (see FIG. 6B) and the bias voltage line VL5 (see FIG. 3B) to which the bias voltage VOBS (see FIG. 3B) is provided.

The tenth conductive pattern C410 may be connected to the first semiconductor pattern ACT1 (see FIG. 6B) and the fourth conductive pattern C34 (see FIG. 6F) of the third conductive layer CDL3 (see FIG. 6F). The tenth conductive pattern C410 may electrically connect the first semiconductor pattern ACT1 (see FIG. 6B) and the second initialization voltage line VL4 (see FIG. 3B) to which the second initialization voltage VAINT (see FIG. 3B) is provided.

The side light shielding pattern SLBP illustrated in FIG. 6G may be the first parts P1-1 and P1-2. The first parts P1-1 and P1-2 of the first and second side patterns SLBP1 and SLBP2 may extend in the first direction DR1. On a plane, the first part P1-1 of the first side pattern SLBP1 and the first part P1-2 of the second side pattern SLBP2 may be spaced apart from each other in the second direction DR2 with the first to tenth conductive patterns C41 to C410 interposed therebetween, the first to tenth conductive patterns C41 to C410 being arranged in the one second pixel row.

FIG. 6G illustrates together a portion in which the side light shielding pattern SLBP is in contact with the lower light shielding pattern BLBP. A portion of the side light shielding pattern SLBP, which is in contact with the lower light shielding pattern BLBP, may correspond to the second parts P2-1 and P2-2. The second part P2-1 of the first side pattern SLBP1 may extend in the first direction DR1 along the first part P1-1 of the first side pattern SLBP1. The second part P2-2 of the second side pattern SLBP2 may extend in the first direction DR1 along the first part P1-2 of the second side pattern SLBP2.

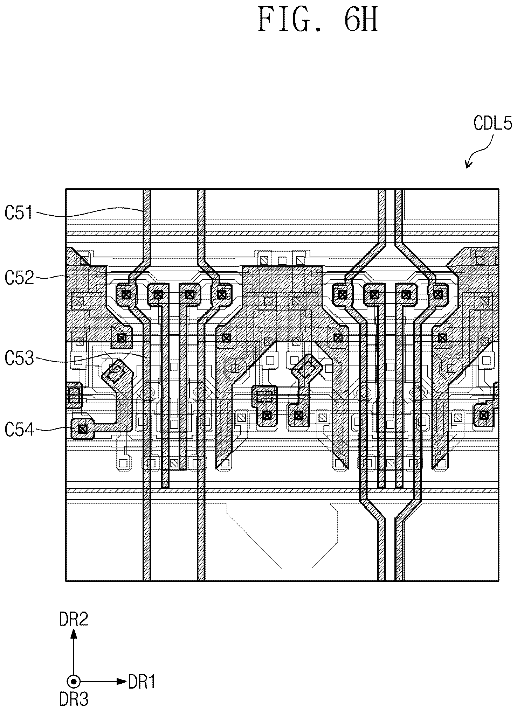

Referring to FIGS. 5B and 6H, a fifth conductive layer CDL5 may be disposed between the sixth insulating layer 60 and the seventh insulating layer 70. The fifth conductive layer CDL5 may include a metal, an alloy, a conductive metal oxide, a transparent conductive material, and/or the like. The fifth conductive layer CDL5 may have a multi-layer structure in which titanium, aluminum, and/or titanium are sequentially laminated, but the present invention is not particularly limited thereto.

The fifth conductive layer CDL5 may include first to fourth conductive patterns C51, C52, C53, and C54. The first to fourth conductive patterns C51, C52, C53, and C54 may be connection electrodes connected to one pattern or a plurality of patterns.

The first conductive pattern C51 may be connected to the second conductive pattern C42 (see FIG. 6G) of the fourth conductive layer CDL4 (see FIG. 6G). The first conductive pattern C51 may correspond to the i^{th} data line DLi of FIG. 3B.

The second conductive pattern C52 may be connected to the fifth conductive pattern C45 (see FIG. 6G) of the fourth conductive layer CDL4 (see FIG. 6G). The second conductive pattern C52 may be a portion of the first driving voltage line VL1 (see FIG. 3B) to which the first driving voltage ELVDD (see FIG. 3B) is provided. The third conductive pattern C53 may be connected to the fifth conductive pattern C45 (see FIG. 6G) of the fourth conductive layer CDL4 (see FIG. 6G).

One end of a fourth conductive pattern C54 may be connected to the eighth conductive pattern C48 (see FIG. 6G) of the fourth conductive layer CDL4 (see FIG. 6G). The fourth conductive pattern C54 may correspond to the third connection electrode CNE3 in FIG. 5B. The other end of the fourth conductive pattern C54 may be connected to the pixel electrode AE(see FIG. 5B) of a corresponding light emitting element from among the (1-2)^{th} to (3-2)^{th} light emitting elements LD2r, LD2g, and LD2b (see FIG. 4B).

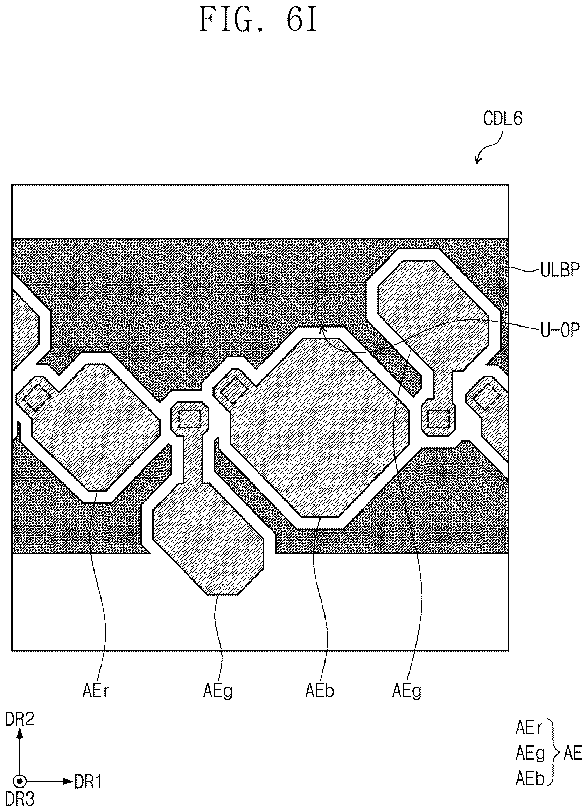

FIG. 6I is a plan view illustrating one layer constituting a light emitting layer disposed in the second area according to one or more embodiments of the present invention.

Referring to FIGS. 4B, 5B, and 6I, a sixth conductive layer CDL6 may be disposed between the seventh insulating layer 70 and pixel defining film PDL. The sixth conductive layer CDL6 may include the pixel electrodes AE and the upper light shielding pattern ULBP. FIG. 6I illustrates pixel electrodes AEr, AEg, and AEb of the (1-2)^{th} light emitting element LD2r, the (2-2)^{th} light emitting element LD2g, the (3-2)^{th} light emitting element LD2b, and the (2-2)^{th} light emitting element LD2g.

In one or more embodiments, the pixel electrode AEr of each light emitting element LD2r may be connected to the fourth conductive pattern C54 (see FIG. 6H) through a contact hole passing through the seventh insulating layer 70.

The upper light shielding pattern ULBP may be disposed to surround at least portions of the pixel electrodes AE on a plane. An inner edge defining the opening U-OP of the upper light shielding pattern ULBP may have a shape extending along edges of the pixel electrodes AE on a plane.

According to one or more embodiments, even when the light beam (e.g., the infrared light beam) emitted from the electronic module 400 (see FIG. 2A) is reflected by the common electrode CE, the light beam reflected by the common electrode CE may be prevented, reduced, or restrained from reaching the transistors due to the upper light shielding pattern ULBP.

In one or more embodiments, the shapes of the patterns that constitute the pixel illustrated in FIGS. 6A to 6I are shown as examples, and the present invention is not necessarily limited thereto. Further, the shapes of the pixel electrodes AE illustrated in FIG. 6I are shown as an example, and the present invention is not necessarily limited thereto.

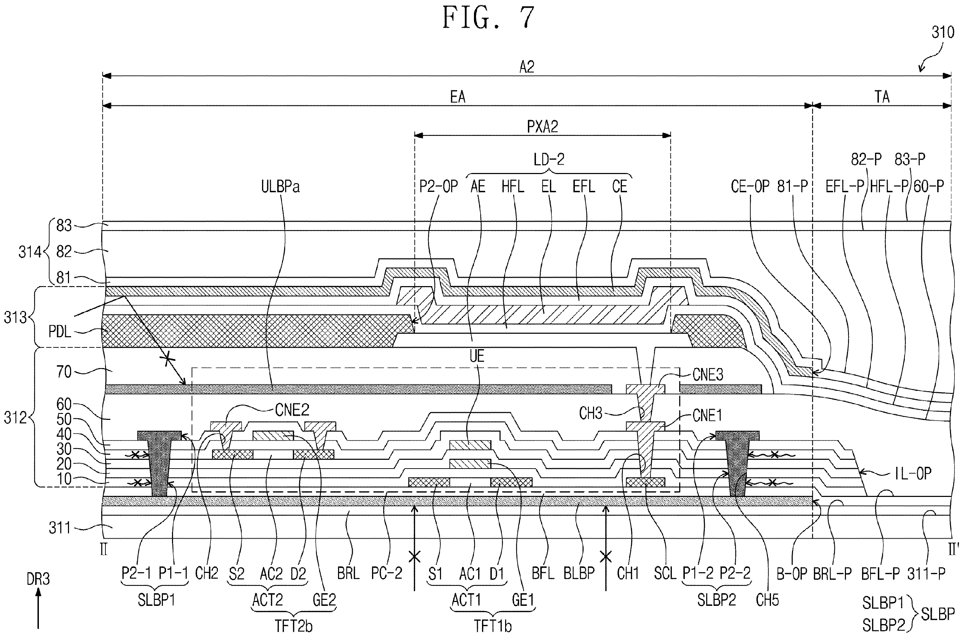

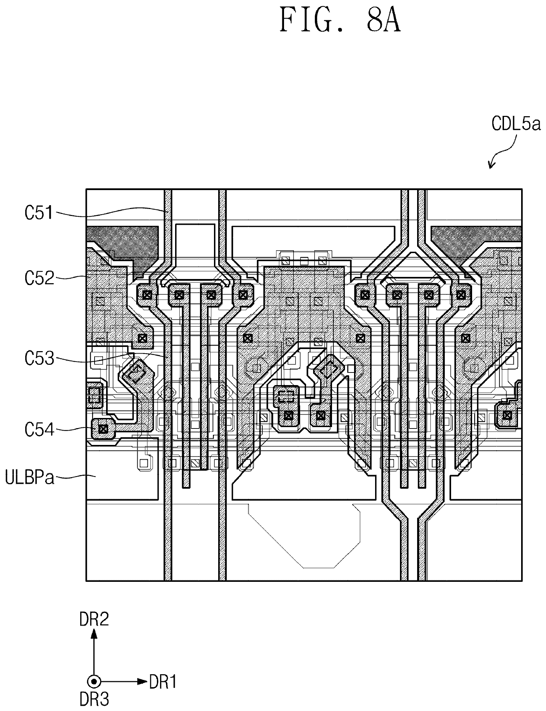

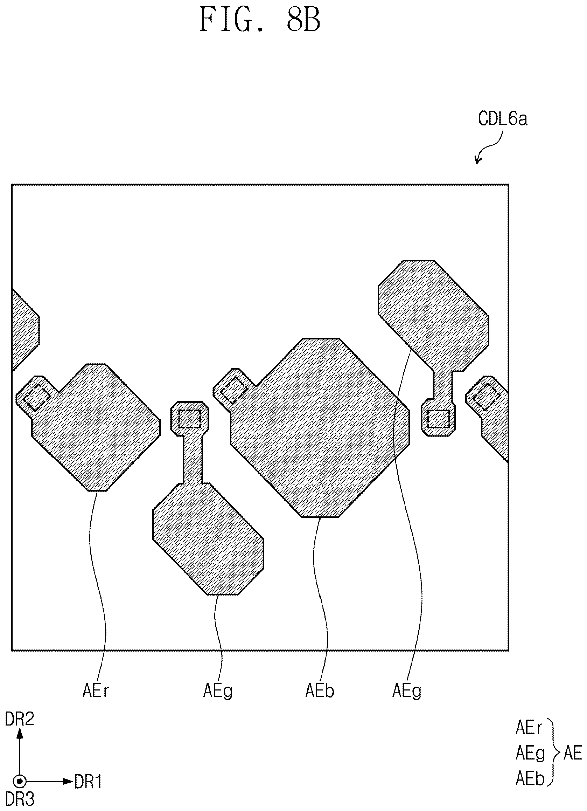

FIG. 7 is a cross-sectional view illustrating the second area of the display panel according to one or more embodiments of the present invention. FIG. 8A is a plan view illustrating one layer constituting the pixel circuits arranged in the second area according to one or more embodiments of the present invention. FIG. 8B is a plan view illustrating one layer constituting the light emitting layer disposed in the second area according to one or more embodiments of the present invention. FIG. 8A illustrates a fifth conductive layer CDL5a disposed between the sixth insulating layer 60 and the seventh insulating layer 70, and FIG. 8B illustrates a sixth conductive layer CDL6a disposed between the seventh insulating layer 70 and the pixel defining film PDL. The same/similar reference numerals are utilized for the same/similar components described in FIGS. 1 to 6I, and a duplicated description thereof will not be provided or repeated.

Referring to FIGS. 7 to 8B, an upper light shielding pattern ULBPa may be disposed in the second area A2. In one or more embodiments, the upper light shielding pattern ULBPa may be disposed on the sixth insulating layer 60 and covered by the seventh insulating layer 70. For example, the upper light shielding pattern ULBPa may be a component included in the fifth conductive layer CDL5a.

As illustrated in FIGS. 8A and 8B, the fifth conductive layer CDL5a according to one or more embodiments may include the first to fourth conductive patterns C51, C52, C53, and C54 and the upper light shielding pattern ULBPa, and the sixth conductivelayer CDL6a may include the pixel electrodes AE. The above description of FIG. 6H may be equally applied to the first to fourth conductive patterns C51, C52, C53, and C54. The description of FIG. 6I may be equally applied to the pixel electrodes AE. The third connection electrode CNE3 of FIG. 7 may correspond to the fourth conductive pattern C54 of FIG. 8A.

The upper light shielding pattern ULBPa may be disposed on (e.g., at) the same layer as that of the first to fourth conductive patterns C51, C52, C53, and C54 and may include the same material as that of the first to fourth conductive patterns C51, C52, C53, and C54. The upper light shielding pattern ULBPa may be formed concurrently (e.g., simultaneously) in a process of forming the first to fourth conductive patterns C51, C52, C53, and C54. In other words, the upper light shielding pattern ULBPa may be disposed on (e.g., at) the same layer as that of the third connection electrode CNE3 and may include the same material as that of the third connection electrode CNE3. Further, the upper light shielding pattern ULBPa may be disposed on (e.g., at) the same layer as that of the i^{th} data line DLi (see FIG. 3B) and the first driving voltage line VL1 (see FIG. 3B) and may include the same material as that of the i^{th} data line DLi (see FIG. 3B) and the first driving voltage line VL1 (see FIG. 3B).

The upper light shielding pattern ULBPa may be spaced from the first to fourth conductive patterns C51, C52, C53, and C54 and may be disposed in a portion in which the first to fourth conductive patterns C51, C52, C53, and C54 are not arranged. In other words, the upper light shielding pattern ULBPa may be spaced from the third connection electrode CNE3 and may be disposed in a portion in which the third connection electrode CNE3 is not arranged. The upper light shielding pattern ULBPa may be spaced from the i^{th} data line DLi (see FIG. 3B) and the first driving voltage line VL1 (see FIG. 3B) and may be disposed in a portion in which the i^{th} data line DLi (see FIG. 3B) and the first driving voltage line VL1 (see FIG. 3B) are not arranged.

An edge of the upper light shielding pattern ULBPa may have a shape extending along some of edges of the first to fourth conductive patterns C51, C52, C53, and C54. FIG. 8A illustrates, as an example, the shape of the upper light shielding pattern ULBPa, and the upper light shielding pattern ULBPa may be disposed in one or more suitable shapes inside the portion in which the first to fourth conductive patterns C51, C52, C53, and C54 are not arranged.

According to one or more embodiments, even when the light beam (e.g., the infrared light beam) emitted from the electronic module 400 (see FIG. 2A) is reflected by the common electrode CE, the light beam reflected by the common electrode CE may be prevented, reduced, or restrained from reaching the transistors due to the upper light shielding pattern ULBPa.

In one or more embodiments, the shapes of the patterns that constitute the pixel illustrated in FIG 8A are shown as examples, and the present invention is not necessarily limited thereto. Further, the shapes of the pixel electrodes AE illustrated in FIG. 8B are shown as examples, and the present invention is not necessarily limited thereto.

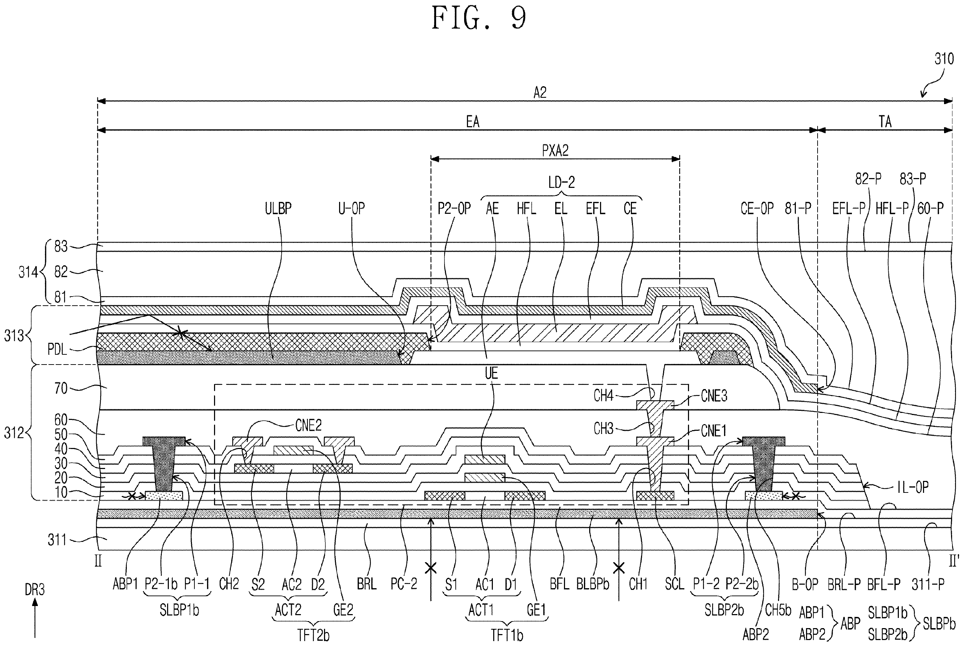

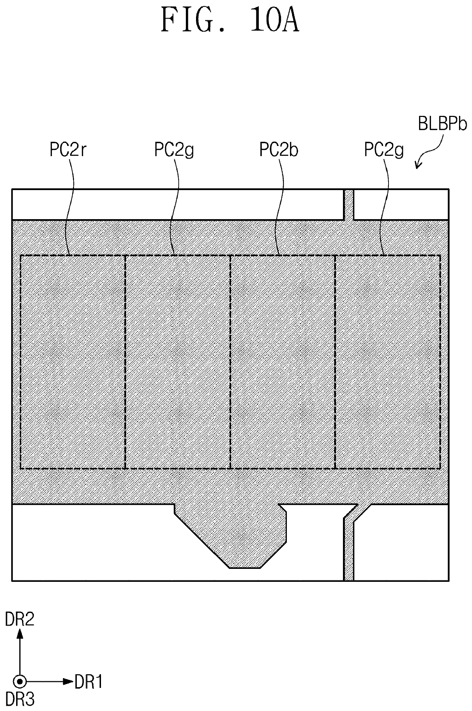

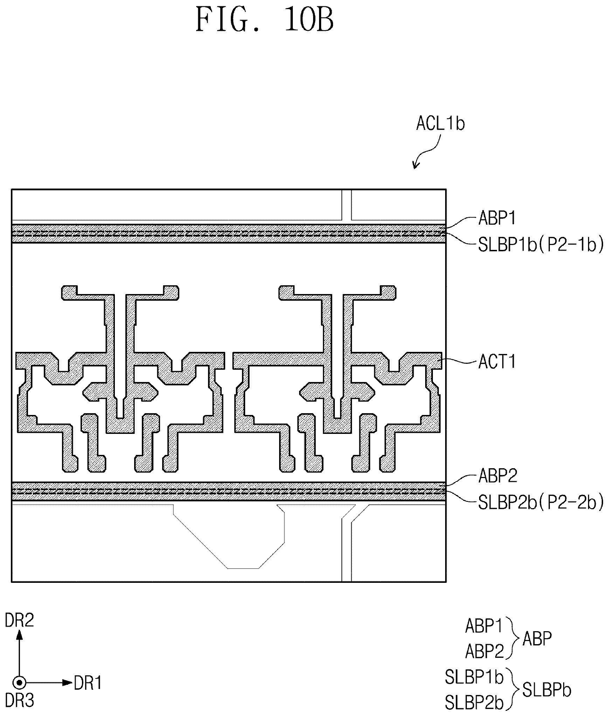

FIG. 9 is a cross-sectional view illustrating the second area of the display panel according to one or more embodiments of the present invention. FIG. 10A is a plan view illustrating a portion of the lower light shielding pattern according to one or more embodiments of the present invention. FIG. 10B is a plan view illustrating the one layer constituting the pixel circuits arranged in the second area according to one or more embodiments of the present invention. The same/similar reference numerals are utilized for the same/similar components described in FIGS. 1 to 6I, and a duplicated description thereof will not be provided.

FIG. 10A illustrates a portion of a lower light shielding pattern BLBPb disposed in the second area A2 (see FIG. 9). In FIG. 10A, the (1-2)^{th} to (3-2)^{th} pixel circuits PC2r, PC2g, and PC2b included in the one second pixel group PXU2 (see FIG. 4B) are illustrated by dotted lines.

FIG. 10B illustrates a first semiconductor layer ACL1b disposed between the buffer layer BFL and the first insulating layer 10. FIG. 10B illustrates components included in the (1-2)^{th} pixel circuit PC2r (see FIG. 10A), the (2-2)^{th} pixel circuit PC2g (see FIG. 10A), the (3-2)^{th} pixel circuit PC2b (see FIG. 10A), and the (2-2)^{th} pixel circuit PC2g (see FIG. 10A), which are arranged inside the one second pixel group PXU2 (see FIG. 4B) along the first direction DR1.

Referring to FIGS. 9 to 10B, the lower light shielding pattern BLBPb may be disposed between the barrier layer BRL and the buffer layer BFL. All the (1-2)^{th} to (3-2)^{th} pixel circuits PC2r, PC2g, and PC2b may be arranged to overlap the lower light shielding pattern BLBPb on a plane.

In one or more embodiments, a light absorbing pattern ABP may be further disposed in the second area A2. The light absorbing pattern ABP may be disposed on the buffer layer BFL and may be covered by the first insulating layer 10. For example, the light absorbing pattern ABP may be a component included in the first semiconductor layer ACL1b.

The light absorbing pattern ABP may be disposed on (e.g., at) the same layer as that of the first semiconductor pattern ACT1. The light absorbing pattern ABP may include the same material as that of the first semiconductor pattern ACT1. The light absorbing pattern ABP may be formed concurrently (e.g., simultaneously) in a process of forming the first semiconductor pattern ACT1. In this case, the light absorbing pattern ABP may be referred to as an additional semiconductor pattern. However, the present invention is not limited thereto, and the light absorbing pattern ABP may include a material that is different from that of the first semiconductor pattern ACT1 and may be formed separately from the first semiconductor pattern ACT1.

The light absorbing pattern ABP may include a first light absorbing pattern ABP1 and a second light absorbing pattern ABP2. Each of the first and second light absorbing patterns ABP1 and ABP2 may extend in the first direction DR1. On a plane, (e.g., in the second direction DR2)the first light absorbing pattern ABP1 may be disposed above the (1-2)^{th} to (3-2)^{th} pixel circuits PC2r, PC2g, and PC2b, and the second light absorbing pattern ABP2 may be disposed below the (1-2)^{th} to (3-2)^{th} pixel circuits PC2r, PC2g, and PC2b in the second direction DR2.

The light beam (e.g., the infrared light beam) emitted from the electronic module 400 (see FIG. 2A) may be transmitted along the first insulating layer 10 including an inorganic layer. However, according to one or more embodiments, the light beam transmitted along the first insulating layer 10 may be absorbed through the light absorbing pattern ABP. Therefore, the light beam emitted from the electronic module 400 (see FIG. 2A) may be prevented, reduced, or restrained from being transmitted to a portion in which the first semiconductor pattern ACT1 is disposed.

In one or more embodiments, a side light shielding pattern SLBPb may be in contact with the light absorbing pattern ABP through a contact hole passing through the first to fifth insulating layers 10 to 50. A first side pattern SLBP1b may be in contact with the first light absorbing pattern ABP1, and a second side pattern SLBP2b may be in contact with the second light absorbing pattern ABP2. On a plane, the first side pattern SLBP1b may overlap at least a portion of the first light absorbing pattern ABP1, and the second side pattern SLBP2b may overlap at least a portion of the second light absorbing pattern ABP2. In one or more embodiments, the side light shielding pattern SLBPb and the lower light shielding pattern BLBPb may not be in contact with each other.

For convenience of description, in FIG. 10B, a portion of the light absorbing pattern ABP, which is in contact with the side light shielding pattern SLBPb, is illustrated by dotted lines. The second part P2-1b and P2-2b of the side light shielding pattern SLBPb may be in contact with the lower light shielding pattern BLBPb. The first light absorbing pattern ABP1 may extend in the first direction DR1 in a direction in which a second part P2-1b of the first side pattern SLBP1b extends. The second light absorbing pattern ABP2 may extend in the first direction DR1 in a direction in which a second part P2-2b of the second side pattern SLBP2b extends.

In one or more embodiments, the transistors TFT1b and TFT2b in the second area A2 may be covered by the side light shielding pattern SLBPb. Therefore, the light beam (e.g., the infrared light beam) emitted from the electronic module 400 (see FIG. 2A), which is introduced to the lateral side of the second pixel circuit PC-2, may be prevented, reduced, or restrained from reaching the transistors TFT1b and TFT2b.

In one or more embodiments, the shapes of the patterns that constitute the pixel illustrated in FIGS. 10A and 10B are shown as an example, and the present invention is not necessarily limited thereto.

According to the present invention, a display panel may include an element area and a transmissive area adjacent to each other in an area of a display area, which overlaps a sensor area, and light shielding patterns may be arranged in the element area. The light shielding patterns may include a lower light shielding pattern, a side light shielding pattern, and an upper light shielding pattern. Therefore, a light beam (e.g., an infrared light beam) provided to the sensor area may be prevented or reduced from being reflected and/or transmitted into the element area. The infrared light beam may be prevented, reduced, or restrained from reaching transistors in the element area, and thus changes in characteristics of the transistors may be restrained, prevented, or reduced. Thus, an electronic device having improved display quality may be provided.

Although the description has been made above with reference to one or more embodiments of the present invention, it may be understood that those skilled in the art or those having ordinary knowledge in the art may variously modify and change the present invention without departing from the technical scope of the present invention described in the appended claims. Accordingly, the technical scope of the present invention is not limited to the detailed description of the specification, but should be defined by the appended claims.

## Claims

1. An electronic device (1000) comprising:
a base layer (311);
at least one transistor (TFT1b) comprising a semiconductor pattern (ACT1) on the base layer (311) and a gate electrode (GE1) on the semiconductor pattern (ACT1);
a connection electrode (CNE1) on the at least one transistor (TFT1b);
at least one insulating layer (10, 20, 30, 40, 50) between the semiconductor pattern (ACT1) and the connection electrode (CNE1);
a side light shielding pattern (SLBP) on a same layer as that of the connection electrode (CNE1); and
a light emitting element (LD-2) on the connection electrode (CNE1) and electrically connected to the at least one transistor (TFT1b),
wherein the connection electrode (CNE1) passes through the at least one insulating layer (10, 20, 30, 40, 50) and is electrically connected to the semiconductor pattern (ACT1), and
wherein the side light shielding pattern (SLBP) passes through the at least one insulating layer (10, 20, 30, 40, 50).

2. The electronic device (1000) of claim 1, wherein the side light shielding pattern (SLBP) extends in one direction on a plane, and
wherein the semiconductor pattern (ACT1) overlaps the side light shielding pattern (SLBP) when viewed in a direction that defines a plane together with the one direction and crosses the one direction.

3. The electronic device (1000) of claim 1 or 2, further comprising:
a lower light shielding pattern (BLBP) located between the base layer (311) and the semiconductor pattern (ACT1),
wherein the at least one transistor (TFT1b) overlaps the lower light shielding pattern (BLBP) on a plane.

4. The electronic device (1000) of claim 3, further comprising:
a lower insulating layer (BFL) between the lower light shielding pattern (BLBP) and the semiconductor pattern (ACT1),
wherein the side light shielding pattern (SLBP) overlaps the lower light shielding pattern (BLBP) on a plane and further passes through the lower insulating layer (BFL) to be in contact with the lower light shielding pattern (BLBP).

5. The electronic device (1000) of at least one of claims 1 to 4, further comprising:
a light absorbing pattern (ABP) on a same layer as that of the semiconductor pattern (ACT1) and comprising a same material as that of the semiconductor pattern (ACT1),
wherein the side light shielding pattern (SLBP) is in contact with the light absorbing pattern (ABP).

6. The electronic device (1000) of at least one of claims 1 to 5, wherein the side light shielding pattern (SLBP) comprises a first side pattern (SLBP1) and a second side pattern (SLBP2) that extend in a first direction (DR1) on a plane and are spaced from each other in a second direction (DR2) crossing the first direction (DR1) with the at least one transistor (TFT1b) interposed therebetween on a plane.

7. The electronic device (1000) of claim 6, wherein the at least one transistor (TFT1b) overlaps the first side pattern (SLBP1) and the second side pattern (SLBP2) when viewed in the second direction (DR2).

8. The electronic device (1000) of claim 6 or 7, further comprising:
a first light absorbing pattern (ABP1) and a second light absorbing pattern (ABP2) that are spaced from each other in the second direction (DR2) with the at least one transistor (TFT1b) interposed therebetween, each of the first light absorbing pattern (ABP1) and the second light absorbing pattern (ABP2) extends in the first direction (DR1), and are arranged on a same layer as that of the semiconductor pattern (ACT1),
wherein the first side pattern (SLBP1) overlaps the first light absorbing pattern (ABP1) and is in contact with the first light absorbing pattern (ABP1), and the second side pattern (SLBP2) overlaps the second light absorbing pattern (ABP2) and is in contact with the second light absorbing pattern (ABP2).

9. The electronic device (1000) of at least one of claims 1 to 8, comprising a plurality of light emitting elements (LD2r, LD2g, LD2b),
the plurality of light emitting elements (LD2r, LD2g, LD2b) comprising:
first light emitting elements (LD2r) each configured to emit a light beam having a first color to a first light emitting area (PXA2);
second light emitting elements (LD2g) each configured to emit a light beam having a second color that is different from the first color to a second light emitting area (PXA2); and
third light emitting elements (LD2b) each configured to emit a light beam having a third color that is different from the first color and the second color to a third light emitting area (PXA2),
wherein one first pixel (PX2r) of the first light emitting elements (LD2r), two second pixels (PX2g) of the second light emitting elements (LD2g), and one third pixel (PX2b) of the third light emitting elements (LD2b) are arranged in one pixel group (PXU2), and
wherein the one pixel group (PXU2) is repeatedly arranged along the first direction (DR1) in one pixel row (PXL2).

10. The electronic device (1000) of claim 9, wherein, in the one pixel group (PXU2), the first light emitting area (PXA2) of the one first pixel (PX2r) and the third light emitting area (PXA2) of the one third pixel (PX2b) are spaced from each other in the first direction (DR1), and the second light emitting areas (PXA2) of the two second pixels (PX2g) are spaced from each other in a direction that crosses the first direction (DR1) and the second direction (DR2) with the third light emitting area (PXA2) of the one third pixel element interposed therebetween.

11. The electronic device (1000) of claim 9 or 10, wherein the base layer (311) comprises:
a component area comprising a transmissive area (TA) and an element area (EA); and
a main display area adjacent to the component area, and
wherein the light emitting elements (LD2r, LD2g, LD2b) overlap the element area (EA) and the main display area and do not overlap the transmissive area (TA).

12. The electronic device (1000) of claim 11, wherein a plurality of transmissive areas (TA) comprising the transmissive area (TA) and a plurality of element areas (EA) comprising the element area (EA) are arranged in the base layer (311), and the transmissive areas (TA) and the element areas (EA) are arranged to alternate with each other in the second direction (DR2) inside the component area, and
wherein the one pixel row (PXL2) overlaps the element areas (EA).

13. The electronic device (1000) of claim 12, wherein the first side pattern (SLBP1) and the second side pattern (SLBP2) are arranged to overlap each of the element areas (EA).

14. The electronic device (1000) of at least one of claims 9 to 13, further comprising:
first pixel circuits (PC2r) electrically connected to respective ones of the first light emitting elements (LD2r);
second pixel circuits (PC2g) electrically connected to respective ones of the second light emitting elements (LD2g); and
third pixel circuits (PC2b) electrically connected to respective ones of the third light emitting elements (LD2b),
wherein each of the first to third pixel circuits (PC2b) comprises the at least one transistor (TFT1b) and the connection electrode (CNE1), and
wherein in the one pixel group (PXU2), one of the first pixel circuits (PC2r), one of two of the second pixel circuits (PC2g), one of the third pixel circuits (PC2b), and another one of the two of the second pixel circuits (PC2g) are arranged along the first direction (DR1).

15. The electronic device (1000) of at least one of claims 1 to 14, further comprising:
an upper light shielding pattern (ULBP) overlapping at least a portion of the semiconductor pattern (ACT1) on a plane,
wherein the light emitting element (LD-2) comprises:
a first electrode (AE) on the connection electrode (CNE1) and electrically connected to the connection electrode (CNE1);
a light emitting layer (EL) on the first electrode (AE); and
a second electrode (CE) on the light emitting layer (EL), and
wherein the upper light shielding pattern (ULBP) is at a same layer as that of the first electrode (AE).

16. The electronic device (1000) of at least one of claims 1 to 15, further comprising:
an upper connection electrode (CNE3) located between the connection electrode (CNE1) and the light emitting element (LD-2) and electrically connected between the connection electrode (CNE1) and the light emitting element (LD-2); and
an upper light shielding pattern (ULBP) overlapping at least a portion of the semiconductor pattern (ACT1) on a plane and located at a same layer as that of the upper connection electrode (CNE3).

17. The electronic device (1000) of at least one of claims 1 to 16, wherein the at least one insulating layer (10, 20, 30, 40, 50) comprises:
a first insulating layer (10) located between the semiconductor pattern (ACT1) and the gate electrode (GE1); and
a second insulating layer (20) located between the gate electrode (GE1) and the connection electrode (CNE1), and
wherein the side light shielding pattern (SLBP) continuously passes through the first insulating layer (10) and the second insulating layer (20).

18. The electronic device (1000) of at least one of claims 1 to 17, further comprising:
at least one additional transistor (TFT2b) comprising an additional semiconductor pattern (ACT2) located in a layer that also passes between the gate electrode (GE1) and the connection electrode (CNE1) and an additional gate electrode (GE2) located in a layer that also passes between the additional semiconductor pattern (ACT2) and the connection electrode (CNE1),
wherein the at least one insulating layer (10, 20, 30, 40, 50) further comprises:
a third insulating layer (30) located between the gate electrode (GE1) and the additional semiconductor pattern (ACT2);
a fourth insulating layer (40) located between the additional semiconductor pattern (ACT2) and the additional gate electrode (GE2); and
a fifth insulating layer (50) located between the additional gate electrode (GE2) and the connection electrode (CNE1), and
wherein the side light shielding pattern (SLBP) continuously passes through the first to fifth insulating layers.

19. The electronic device (1000) of at least one of claims 1 to 18, wherein the side light shielding pattern (SLBP) comprises a same material as that of the connection electrode (CNE1).

20. An electronic device (1000) comprising:
a pixel circuit (PC) comprising at least one transistor (TFT1b, TFT2b)comprising semiconductor patterns (ACT1, ACT2) and a gate electrode (GE1, GE2) on the semiconductor patterns (ACT1, ACT2);
a light emitting element (LD-2) electrically connected to the pixel circuit (PC); and
a side light shielding pattern (SLBP) comprising a first side pattern (SLBP1) and a second side pattern (SLBP2) that are spaced from each other in one direction with the pixel circuit (PC) interposed therebetween on a plane,
wherein the semiconductor patterns (ACT1, ACT2) overlap each of the first side pattern (SLBP1) and the second side pattern (SLBP2) when viewed in the one direction.
